(19) Europäisches Patentamt / European Patent Office / Office européen des brevets

(11) **EP 3 282 288 B1**

(12) **EUROPEAN PATENT SPECIFICATION**

(45) Date of publication and mention
of the grant of the patent:
**17.08.2022   Bulletin 2022/33**

(21) Application number: **16830467.3**

(22) Date of filing: **22.07.2016**

(51) International Patent Classification (IPC):
***G01T 1/29*** *(2006.01)*      ***G01T 1/16*** *(2006.01)*
***G01T 1/36*** *(2006.01)*

(52) Cooperative Patent Classification (CPC):
**G01T 1/2907; H01L 27/14676**

(86) International application number:
**PCT/JP2016/071641**

(87) International publication number:
**WO 2017/018362 (02.02.2017 Gazette 2017/05)**

(54) **RADIATION MEASURING APPARATUS AND RADIATION MEASURING METHOD**

STRAHLUNGSMESSVORRICHTUNG UND STRAHLUNGSMESSVERFAHREN

APPAREIL ET PROCÉDÉ DE MESURE DE RAYONNEMENT

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **24.07.2015   JP 2015147065**

(43) Date of publication of application:
**14.02.2018   Bulletin 2018/07**

(73) Proprietors:
• **Mitsubishi Heavy Industries, Ltd.
Tokyo 108-8215 (JP)**
• **Japan Aerospace Exploration Agency
Chofu-shi, Tokyo 182-8522 (JP)**

(72) Inventors:
• **GEMBA Kei
Tokyo 108-8215 (JP)**
• **KURODA Yoshikatsu
Tokyo 108-8215 (JP)**

• **MATSUURA Daisuke
Tokyo 108-8215 (JP)**
• **TAKAHASHI Tadayuki
Sagamihara-shi
Kanagawa 252-5210 (JP)**
• **WATANABE Shin
Sagamihara-shi
Kanagawa 252-5210 (JP)**
• **TAKEDA Shin'ichiro
Sagamihara-shi
Kanagawa 252-5210 (JP)**

(74) Representative: **Henkel & Partner mbB
Patentanwaltskanzlei, Rechtsanwaltskanzlei
Maximiliansplatz 21
80333 München (DE)**

(56) References cited:
WO-A1-2012/077468      WO-A2-01/01167
JP-A- 2005 208 057      JP-A- 2010 032 451
JP-A- 2011 085 418      JP-A- 2015 075 424
US-A1- 2004 251 419     US-A1- 2008 128 631

EP 3 282 288 B1

**Description**

**Technical Field**

The present invention relates to a radiation measuring apparatus and a radiation measuring method, and especially, to an apparatus and a method for measuring electromagnetic radiation (e.g. X-ray, gamma ray) by using Compton scattering.

**Background Art**

A Compton camera is a type of radiation measuring apparatus that can image a spatial distribution of radiation sources. The Compton camera specifies incidence directions of the electromagnetic radiations (e.g. X-ray, gamma ray) by using the Compton scattering, and generates an image showing a spatial distribution of radiation sources from the specified incidence directions.

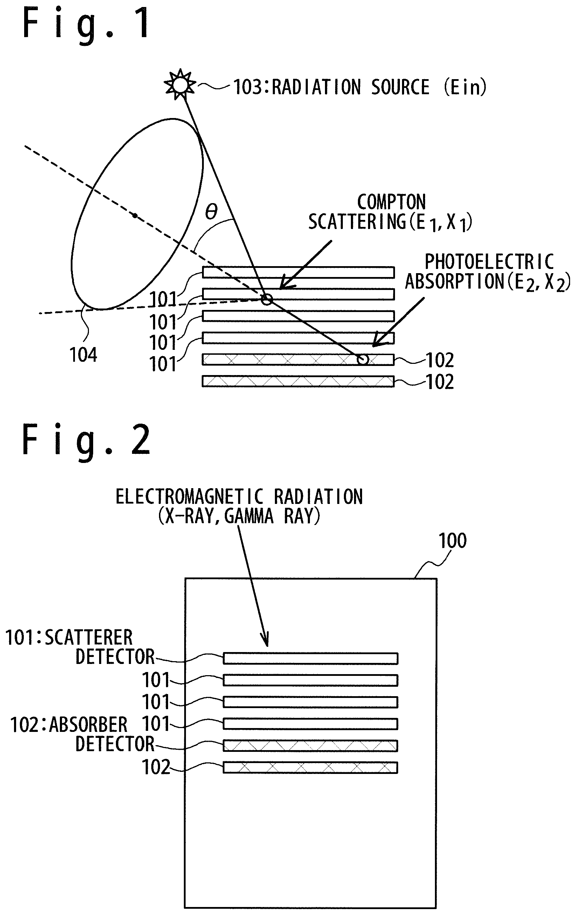

FIG. 1 is a diagram showing the principle of Compton camera, especially, the principle of specifying the incidence direction of the electromagnetic radiation. A detecting section of the Compton camera typically has scatterer detectors 101 and absorber detectors 102. In order to improve detection efficiency, there is a case that the scatterer detectors 101 and the absorber detectors 102 are arranged to form a structure of layers. In the detecting section of such a configuration, when an event has occurred in which a photon of electromagnetic radiation inputted from a radiation source 103 is Compton-scattered in the scatterer detector 101, and the Compton-scattered photon is absorbed by the absorber detector 102 through the photoelectric absorption, a scattering angle $\theta$ of the electromagnetic radiation (in other words, an angle between a line segment linking the radiation source 103 and a position $X_1$ and a straight line which passes the position $X_1$ and a position $X_2$) is given by the following equation (1).

$$\cos\theta = 1 - m_e c^2 \left( \frac{1}{E_2} - \frac{1}{E_1 + E_2} \right) \qquad \cdots (1)$$

Here, $m_e$ is an electron rest mass, and c is speed of light. Also, $E_1$ is energy acquired by a recoil electron through the Compton scattering in the scatterer detector 101, $E_2$ is energy of the photon absorbed by the absorber detector 102.

In the Compton camera, the spatial distribution of radiation sources 103 is estimated based on data of the scattering angles $\theta$ of the electromagnetic radiations obtained in this way, so as to image the spatial distribution of radiation sources 103. More specifically, a Compton cone 104 for each event (a cone surface configured by a set of points where the radiation sources could be located) is reconfigured from the data of a position X1 of occurrence of the Compton scattering, a position X2 of occurrence of the photoelectric absorption, and the scattering angle $\theta$ of the Compton scattering in each event. An image obtained by superimposition of the Compton cones 104 for each event is generated as a radiation source distribution image showing the spatial distribution of radiation sources 103.

Note that JP 2011-85418A discloses a radiation measuring apparatus for measuring radiation by the suitable method according to the energy of radiation. The radiation measuring apparatus has a first measurement mode for obtaining a radiation source distribution image according to the principle of Compton camera, and a second measurement mode for obtaining a radiation source distribution image through the maximum likelihood estimation expected value maximization calculation based on a response characteristic of the detection structure and an actual detection result.

US 2004/251419 A1 discloses detection of Compton scattering by a scatterer detector and photoelectric absorption by an absorber detector of different modules.

**Citation List**

[Patent Literature 1] JP 2011-85418A
[Patent Literature 2] US 2004/251419A1

**Summary of the Invention**

According to the consideration by the inventors, one of problems of the current Compton camera is in that the Compton camera cannot flexibly deal with a difference in the nature of radiation source. In other words, the current Compton camera is difficult to flexibly deal with various requests to the Compton camera. For example, the energy and flux of irradiated electromagnetic radiation change variously. However, the current Compton camera is difficult to change its configuration freely to deal with the difference of the energy and flux. If a radiation measuring apparatus with a high flexibility for radiation sources is provided, a user can carry out various measurements by the identical radiation measuring apparatus, and the convenience to the user is improved. For the manufacturer of the radiation measuring apparatus, too, there is a merit that the manufacture needs not to manufacture various types of radiation measuring apparatus according to the difference in the radiation sources.

Giving more specific examples, the following requests are given to the Compton camera:

(a) A high energy resolution to identify various nuclear gamma rays (e.g. ΔE/E is about 3%).
(b) A high resolution of an arrival direction of gamma ray to specify the position where the radiation sources are integrated and a distance to the position (e.g. equal to or less than 10 degrees in angle resolution).
(c) A sensitivity necessary to visualize in a short time, the integration of low-concentration radioactive substances which are made necessary to manage at a site.
(d) A wide field of view corresponding to the integration of radiation sources in various conditions.
(e) A compact size so as to be possible to install in the neighborhood of a human body and so on for medical applications.
(f) An angle resolution to identify the integration of radiation sources of a sub mm order to 1 mm in size in the human body for the medical applications.
(g) Measurement performance to be possible to measure a very high radiation flux (high concentration radioactive substances) without piling up.

If the Compton camera having the configuration possible to flexibly deal with such requests is provided, the user convenience can be improved.

Therefore, one of the objects of the present invention is to provide a radiation measuring apparatus which can flexibly deal with a difference in the nature of radiation source.

The other objects and features of the present invention would be understood from the following description and the attached drawings.

According to the present invention, there is provided a radiation measuring apparatus as set out in independent claim 1, and a radiation measuring method as set out in independent claim 7. Advantageous developments are defined in the dependent claims.

In the radiation measuring apparatus having such a configuration, by arranging the plurality of detector modules according to the nature of radiation sources, it is possible to flexibly deal with a difference in the nature of radiation sources.

In one embodiment, the processing unit is configured: to reconfigure a Compton cone corresponding to each of events, when each event, in which Compton scattering has occurred in the scatterer detector of a first detector module of the plurality of detector modules and photoelectric absorption of a photon scattered in the Compton scattering has occurred is in the absorber detector of a second detector module of the plurality of detector modules which is different from the first detector module, is detected based on the digital communication data received from the plurality of detector modules, and to generate the radiation source distribution image based on the Compton cones.

In one embodiment, the processing unit supplies a synchronization data or a synchronization signal to each of the plurality of detector modules, and each of the a plurality of detector modules generates the digital communication data to contain measurement time data generated in synchronization with the synchronization data or the synchronization signal. In this case, the processing unit detects, based on the measurement time data, occurrence of the event in which the Compton scattering occurs in the scatterer detector of the first detector module, and in which the photoelectric absorption of the photon scattered in the Compton scattering occurs in the absorber detector of the second detector module. According to such a configuration, even if the Compton scattering and the photoelectric absorption occur in the different detector modules, it is possible to surely detect that the Compton scattering and the photoelectric absorption are related to the identical photon.

In one embodiment, the digital processing section of each of the plurality of detector modules is configured to specify a scattering position of the occurrence of the Compton scattering and first energy as energy given to recoil electron in the Compton scattering based on the digital measurement data in the scatterer detector of the plurality of detectors, and to generate the digital communication data to contain data showing the scattering position and the first energy.

In another embodiment, the digital processing section of each of the plurality of detector modules is configured to specify an absorption position of the occurrence of the photoelectric absorption and a second energy as energy absorbed in the photoelectric absorption based on the digital measurement data in the absorber detector of the plurality of detectors, and to generate the digital communication data to contain data showing the absorption position and the second energy.

Also, at least one of the plurality of detectors contained in each of the plurality of detector modules is the scatterer detector, and at least one of the plurality of detectors contained in each of the plurality of detector modules is the absorber detector. In this case, the digital processing section of each of the plurality of detector modules is configured to specify the scattering position of the occurrence of the Compton scattering and the first energy as the energy given to the recoil electron in the Compton scattering based on the digital measurement data in the scatterer detector of the plurality of detectors, to specify the absorption position of the occurrence of the photoelectric absorption and the second energy as the energy absorbed by the photoelectric absorption based on the digital measurement data in the absorber detector of the plurality of detectors, and to generate the digital communication data to contain data showing the scattering position, the first energy, the absorption position and the second energy.

According to these configurations, the data quantity of the digital communication data to be sent to the processing unit can be reduced.

In one embodiment, the number of scatterer detectors is identical over the plurality of detector modules, and the number of absorber detectors is identical over the plurality of detector modules. Desirably, the plurality of detector modules have an identical configuration. According to such a configuration, the cost of each detector module can be reduced.

In one embodiment, the digital processing section of each of the plurality of detector modules transmits the digital communication data to the processing unit by a wireless communication. According to such a configuration, the number of degrees of freedom of the arrangement of the plurality of detector modules can be improved.

Each of the plurality of detector modules comprises a housing configured to accommodate the plurality of detectors, the plurality of analog signal processing sections, and the digital processing section, and the housing of each of the plurality of detector modules has a coupling mechanism to connect the housing of another of the plurality of detector modules. In this case, it is desirable that the housing of each of the plurality of detector modules has a coupling mechanism to connect the housing of another of the plurality of detector modules. According to such a configuration, the relative position relation of the plurality of detector modules can be surely fixed.

According to the present invention, the radiation measuring apparatus can be provided which can flexibly deal with a difference in the nature of radiation sources.

**Brief Description of the Drawings**

[FIG. 1]
FIG. 1 is a diagram showing the principle of Compton camera, especially, the principle of specifying an incidence direction of electromagnetic radiation.
[FIG. 2]
FIG. 2 is a diagram showing an example of configuration of a detecting section of the Compton camera.
[FIG. 3]

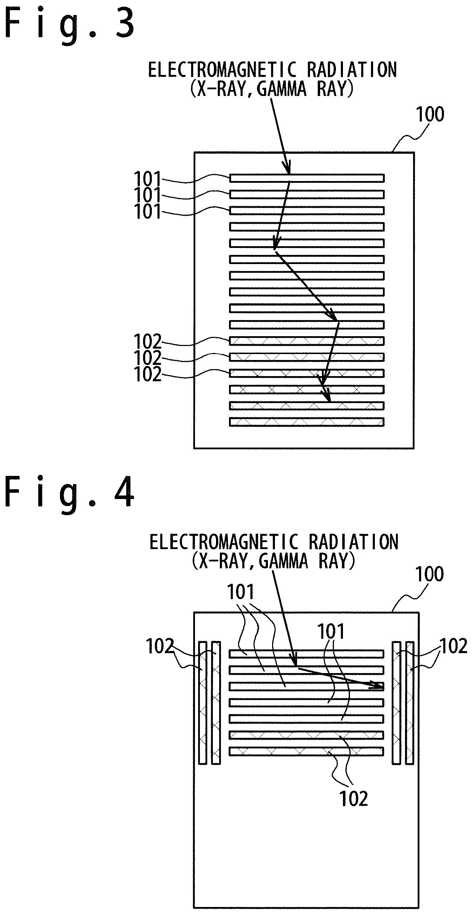

FIG. 3 is a diagram showing another example of configuration of the detecting section of the Compton camera.
[FIG. 4]
FIG. 4 is a diagram showing another example of configuration of the detecting section of the Compton camera.
[FIG. 5]

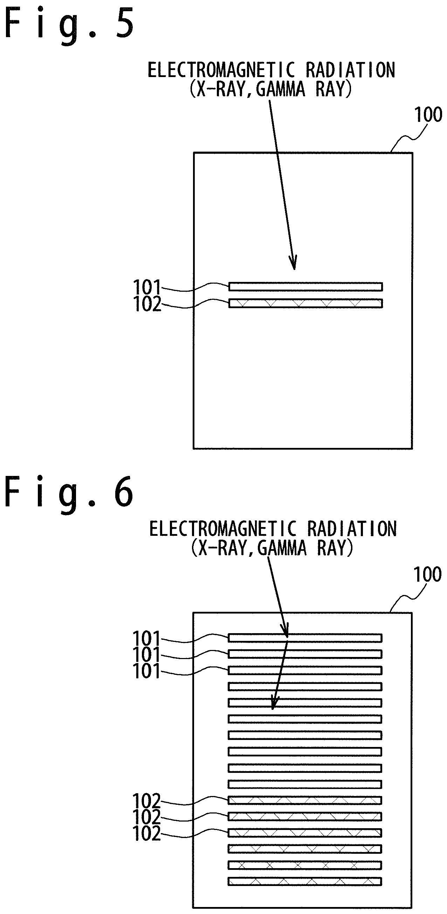

FIG. 5 is a diagram showing another example of configuration of the detecting section of the Compton camera.
[FIG. 6]
FIG. 6 is a diagram showing another example of configuration of the detecting section of the Compton camera.
[FIG. 7]

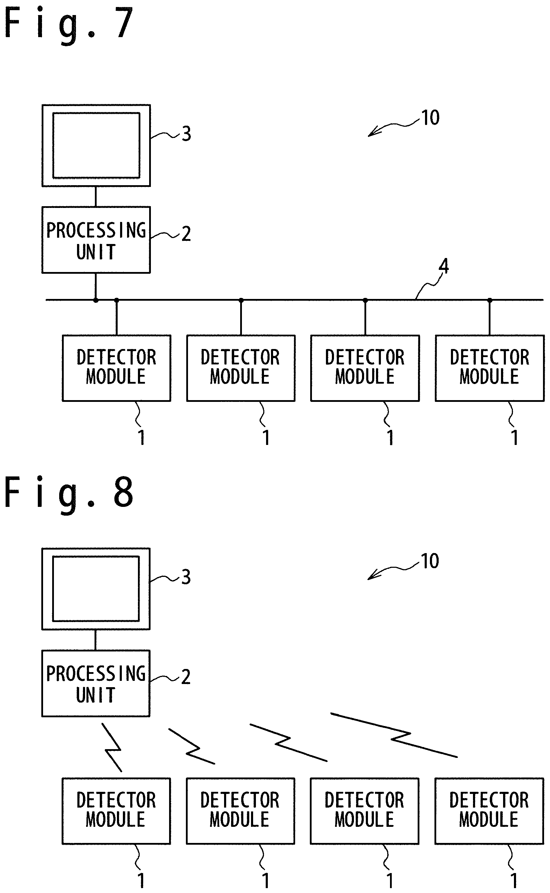

FIG. 7 is a block diagram showing the configuration of radiation measuring apparatus according to one embodiment of the present invention.
[FIG. 8]
FIG. 8 is a block diagram showing a modification example of configuration of the radiation measuring apparatus according to one embodiment of the present invention.
[FIG. 9]

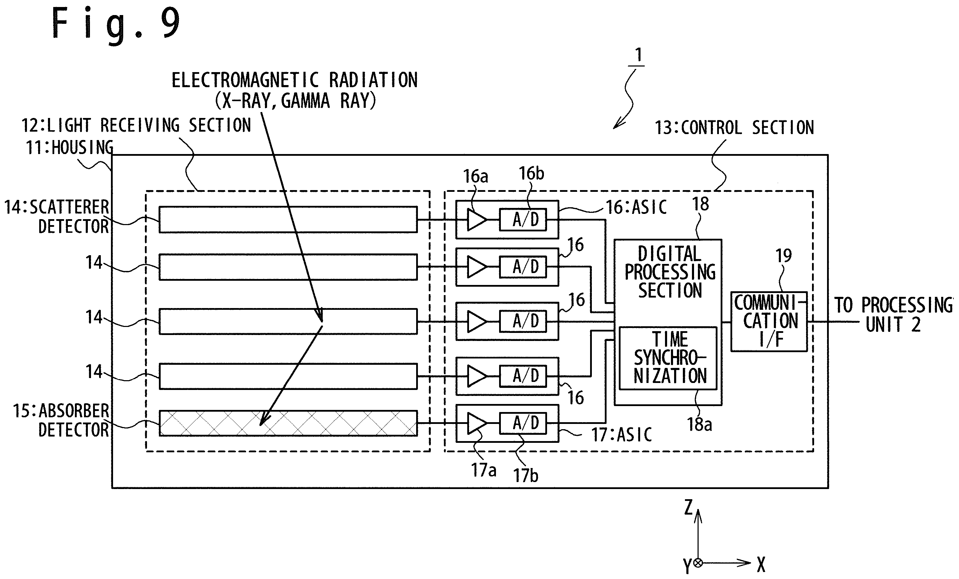

FIG. 9 is a block diagram showing an example of configuration of a detector module in one embodiment.
[FIG. 10A]

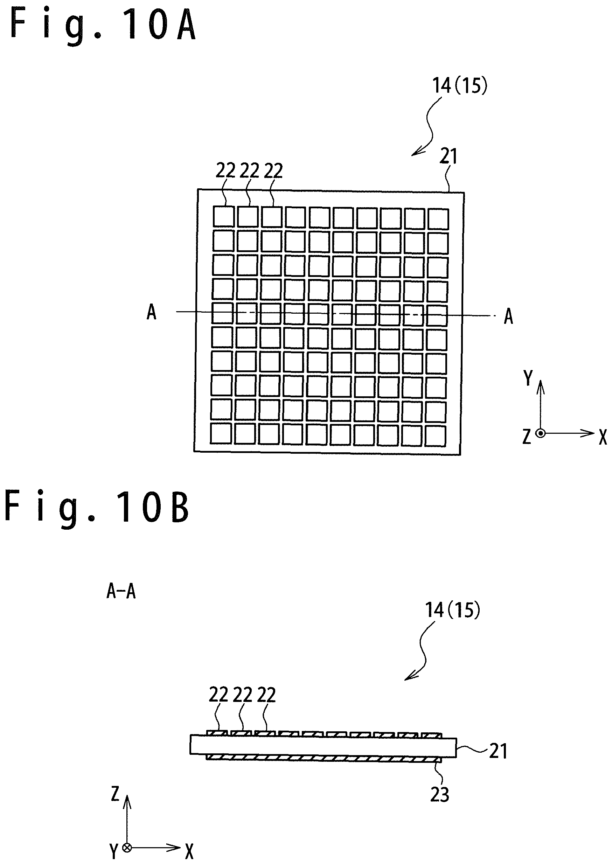

FIG. 10A is a plan view showing an example of configuration of scatterer detectors and absorber detectors in this embodiment.
[FIG. 10B]
FIG. 10B is a sectional view showing an example of configuration of the scatterer detector and the absorber detector in this embodiment.

[FIG. 11A]

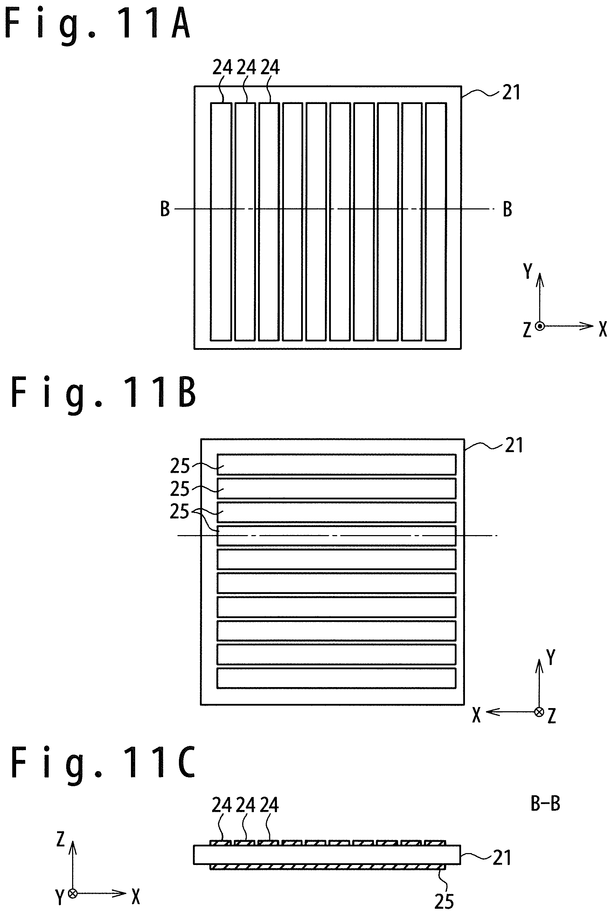

FIG. 11A is a top view showing another example of configuration of the scatterer detector and the absorber detector in this embodiment.
[FIG. 11B]
FIG. 11B is a bottom view showing another example of configuration of the scatterer detectors and the absorber detectors in this embodiment.
[FIG. 11C]
FIG. 11C is a sectional view showing another example of configuration of the scatterer detector and the absorber detector in this embodiment.
[FIG. 12A]

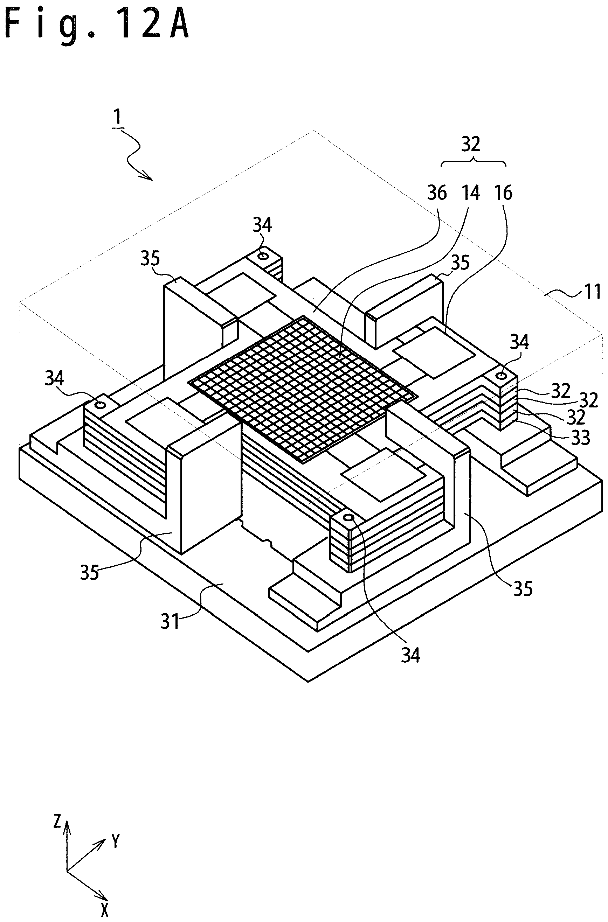

FIG. 12A is a perspective view showing an example of configuration of a detector module in this embodiment.
[FIG. 12B]

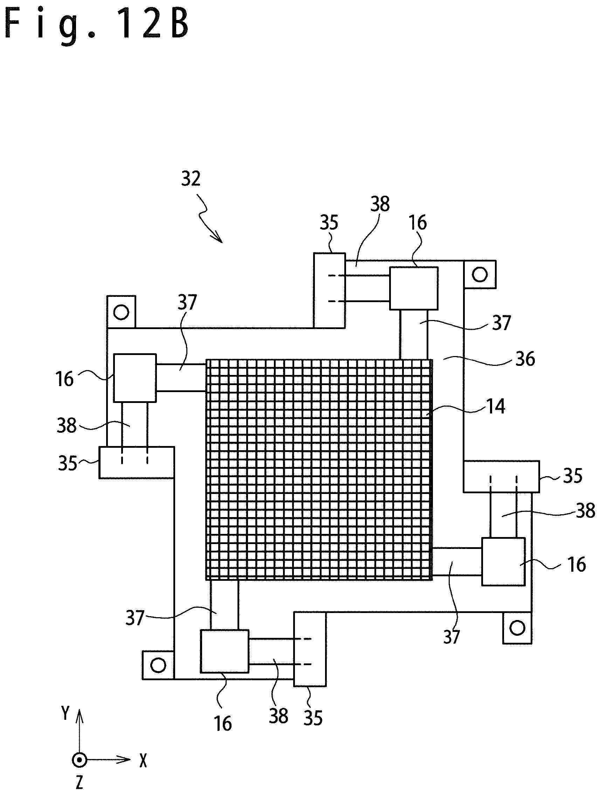

FIG. 12B is a plan view showing an example of configuration of the detector board in this embodiment.
[FIG. 12C]

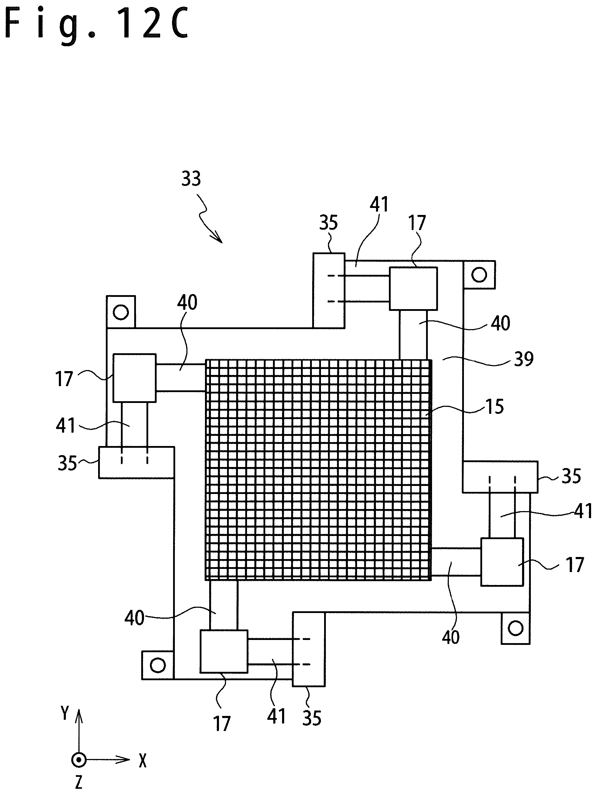

FIG. 12C is a plan view showing an example of configuration of the detector board in this embodiment.
[FIG. 13]

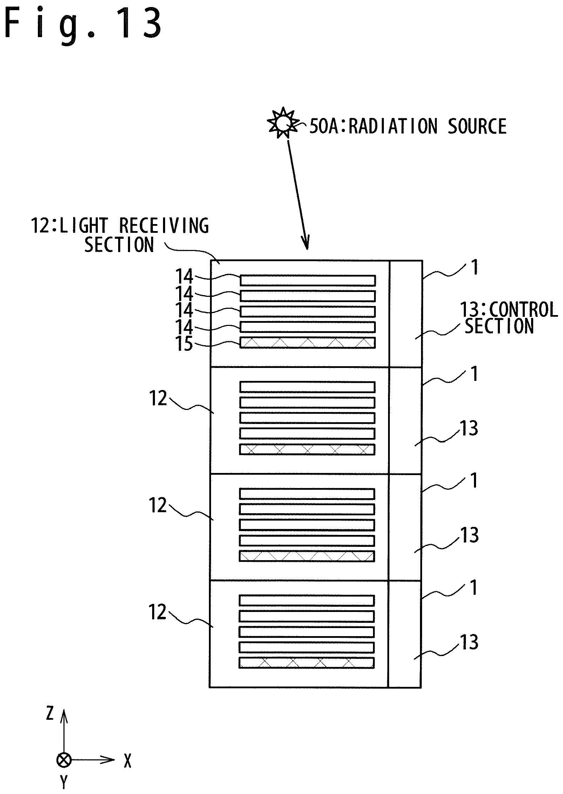

FIG. 13 is a conceptual diagram showing an example of arrangement of the detector modules in this embodiment.
[FIG. 14]

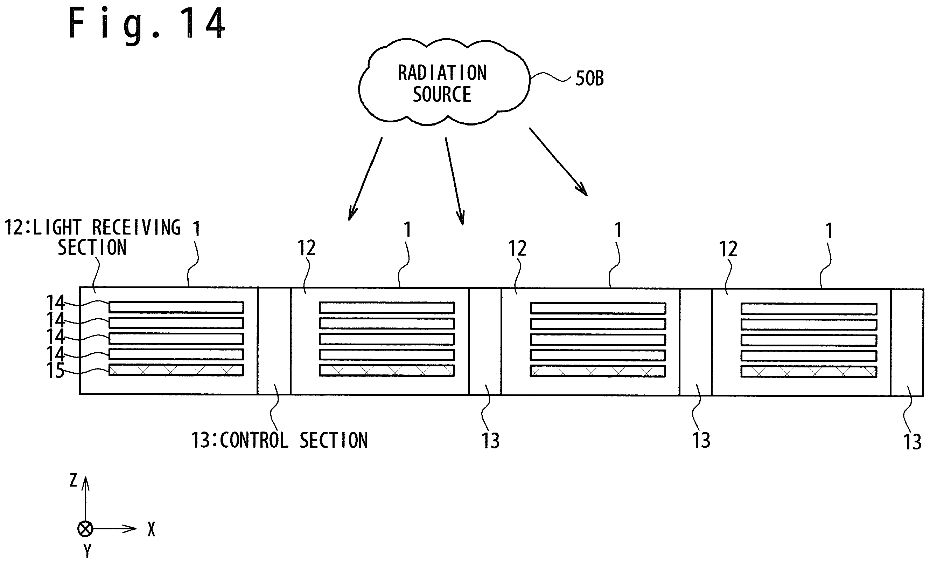

FIG. 14 is a conceptual diagram showing another example of arrangement of the detector modules in this embodiment.
[FIG. 15]

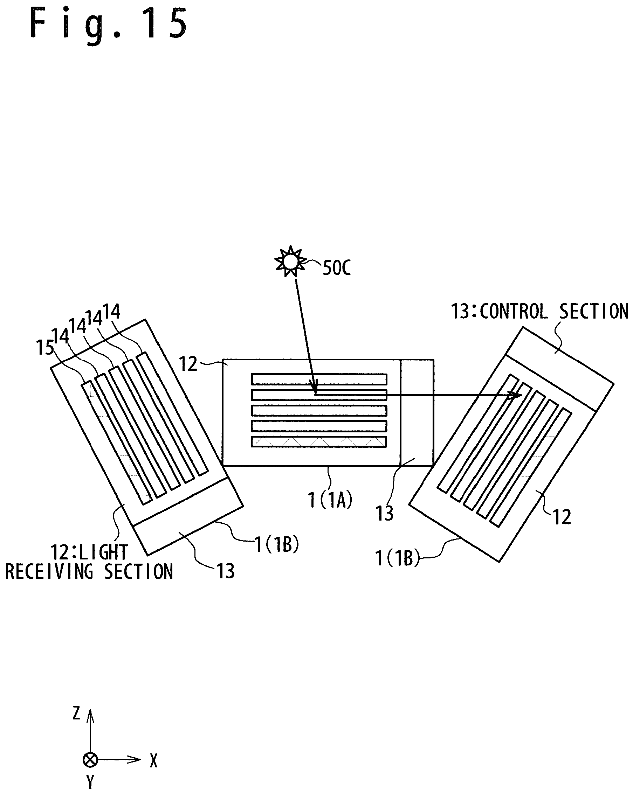

FIG. 15 is a conceptual diagram showing another example of arranging of the detector module in this embodiment.
[FIG. 16]

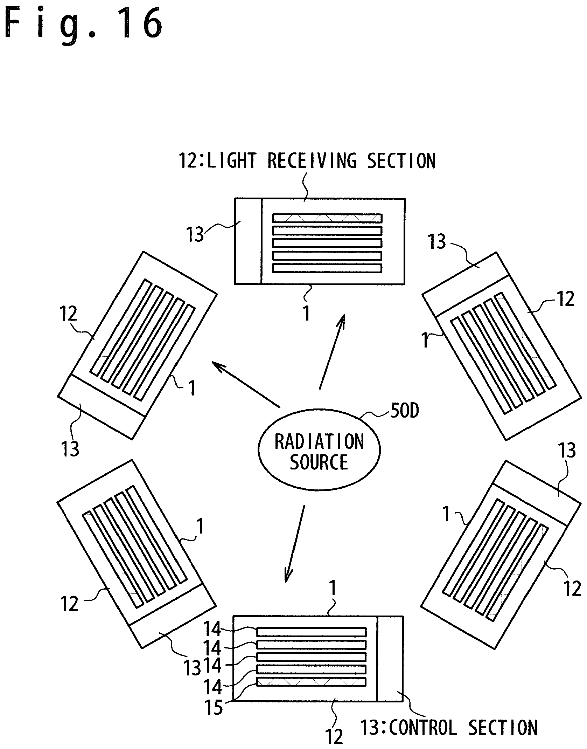

FIG. 16 is a conceptual diagram showing another example of arrangement of the detector modules in this embodiment.
[FIG. 17]

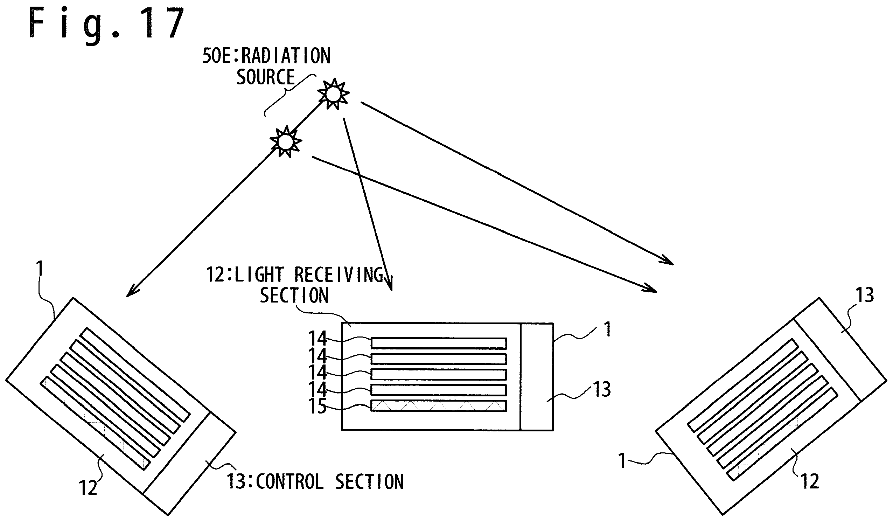

FIG. 17 is a conceptual diagram showing another example of arrangement of the detector modules in this embodiment.
[FIG. 18A]

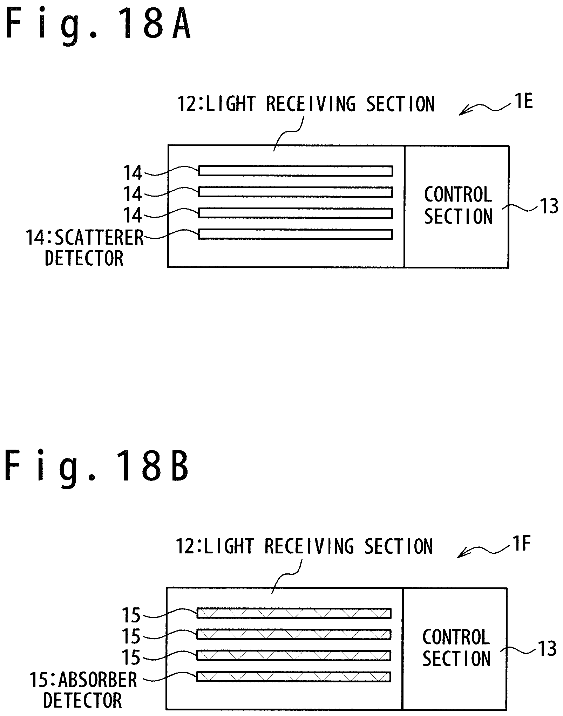

FIG. 18A is a conceptual diagram showing a modification example of configuration of the detector module not forming part of the present invention.
[FIG. 18B]
FIG. 18B is a conceptual diagram showing a modification example of configuration of the detector module not forming part of the present invention.
[FIG. 19A]

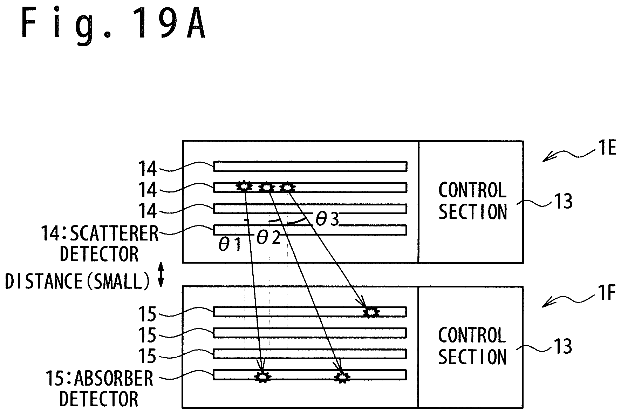

FIG. 19A is a conceptual diagram showing an example of arrangement of the detector modules not forming part of the present invention, to expand a viewing angle.
[FIG. 19B]

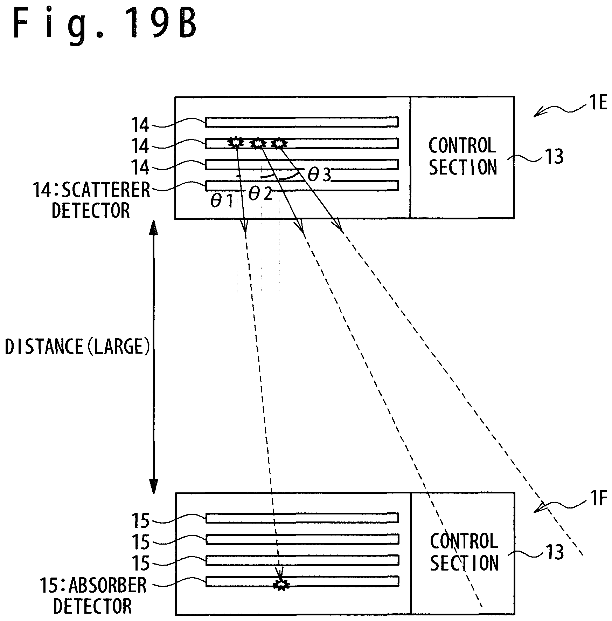

FIG. 19B is a conceptual diagram showing an example of arrangement of the detector module not forming part of the present invention, to improve an angle resolution.
[FIG. 20]

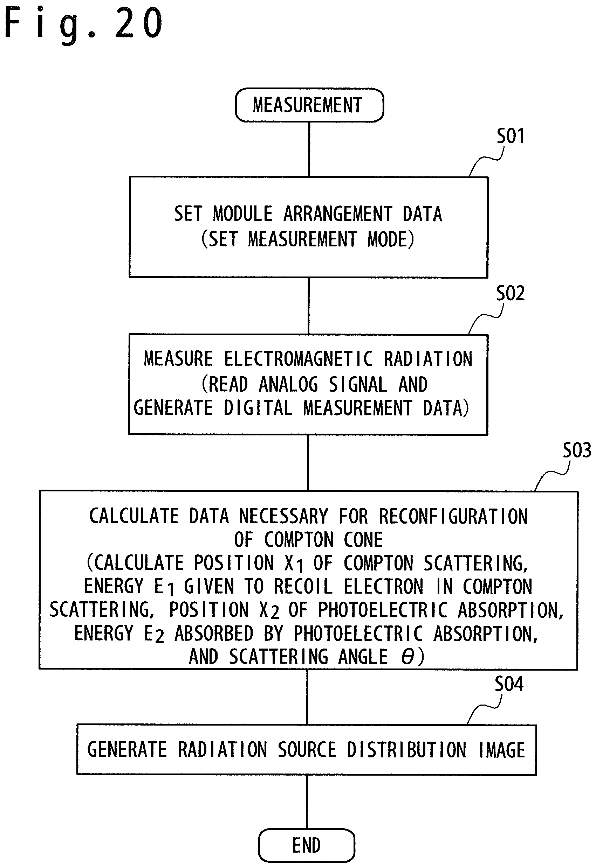

FIG. 20 is a flow chart showing a procedure of generation of a radiation source distribution image according to an embodiment of the invention.
[FIG. 21A]

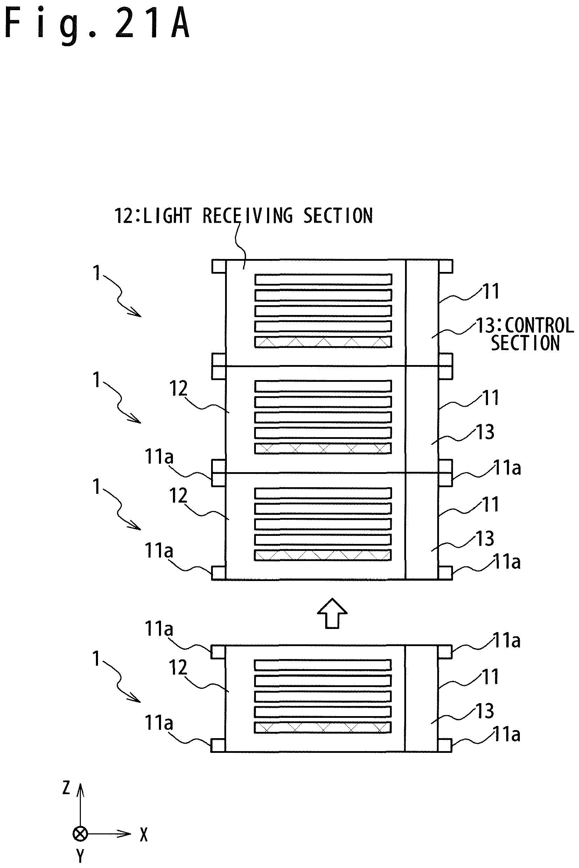

FIG. 21A is a diagram showing an example of connection of the detector modules by using connection mechanisms provided for housings in an embodiment of the present invention.
[FIG. 21B]

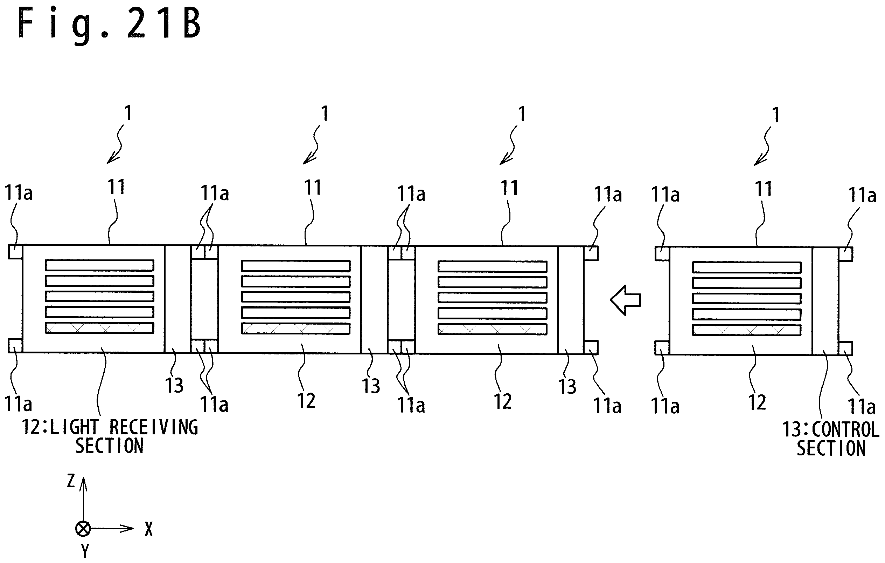

FIG. 21B is a diagram showing another example of connection of the detector modules by using the connection mechanisms provided for the housings in this embodiment.

## Description of Embodiments

First, problems of a general Compton camera will be described to facilitate the understanding of technical meaning of the present invention.

FIG. 2 is a diagram schematically showing a typical configuration of a detecting section 100 of the Compton camera. As shown in FIG. 2, in the detecting section 100 of the Compton camera, typically, scatterer detectors 101 are provided for the incidence side of electromagnetic radiation, and absorber detectors 102 are provided on the rear side. Generally, a plurality of scatterer detectors 101 are provided to increase an occurrence probability of Compton scattering in the scatterer detector 101, and also, a plurality of absorber detectors 102 are provided to increase an absorption probability of photoelectric absorption.

However, the detecting section 100 of the Compton camera having such a configuration is difficult to flexibly deal with a difference in the nature of a radiation source. For example, when electromagnetic radiation in a high energy level should be measured, it is desirable that the number of scatterer detectors 101 and the number of absorber detectors 102 are increased which are arranged in a layer direction of the layer, as shown in FIG. 3. This is because an occurrence probability of Compton scattering and an absorption probability of photoelectric absorption are low in the electromagnetic radiation in the high energy level, and because the scattering angle of the Compton scattering is small.

On the other hand, when the electromagnetic radiation in a low energy level is measured, it is desirable that the number of scatterer detectors 101 and the number of absorber detectors 102 are decreased which are arranged in a layer direction, and the absorber detectors 102 are provided for the side of the scatterer detectors 101, in addition to the rear side of the scatterer detectors 101, as shown in FIG. 4. This is because the occurrence probability of Compton scattering and the absorption probability of photoelectric absorption are high for the electromagnetic radiation in the low energy level and because the scattering angle of the Compton scattering is large. The absorber detectors 102 provided on the side of scatterer detectors 101 are useful to capture a photon of the electromagnetic radiation scattered in a large scattering angle.

Moreover, when the electromagnetic radiation in a high flux level is measured, it is desirable that the number of scatterer detectors 101 and the number of absorber detectors 102 are decreased, which are arranged in the layer direction, as shown in FIG. 5. On the other hand, when the electromagnetic radiation in a low flux level is measured, it is desirable that the number of scatterer detectors 101 and the number of absorber detectors 102 are increased, which are arranged in the layer direction, as shown in FIG. 6, in case of measurement of the electromagnetic radiation in a high sensitivity.

In this way, the desirable configuration of the detecting section 100 of the Compton camera is different according to the nature of radiation source. Saying oppositely, this means that it is difficult to properly measure the electromagnetic radiation emitted from radiation sources with various natures by the detecting section 100 having a specific configuration. In the embodiments of the present invention to be described below, the radiation measuring apparatus that can deal with such a problem and that can flexibly deal with a difference in the nature of radiation source will be described.

FIG. 7 or FIG. 8 is a block diagram showing a configuration of the radiation measuring apparatus 10 according to one embodiment of the present invention. In the present embodiment, the radiation measuring apparatus 10 includes a plurality of detector modules 1, a processing unit 2 and a display device 3. The plurality of detector modules 1 and the processing unit 2 are connected to be communicable. In the embodiment, as shown in FIG. 7, the plurality of detector modules 1 and the processing unit 2 may be connected through wired lines, more specifically, a wired network 4 (e.g. wired LAN (local area network)). Also, as shown in FIG. 8, the plurality of detector modules 1 and the processing unit 2 may be connected by radio communication (e.g. wireless LAN). The connection between the plurality of detector modules 1 and the processing unit 2 by the radio communication is useful in the points that the necessity of connection between the detector module 1 and the processing unit 2 by a wiring line is eliminated and that it is possible to improve degrees of freedom in the arrangement of the detector modules 1.

A plurality of detectors are loaded on each detector module 1 to detect ionizing radiation. As described later, each detector module 1 is configured to transmit generated digital communication data to the processing unit 2 based on analog signals outputted from the plurality of detectors loaded on the detector module 1. The processing unit 2 generates a radiation source distribution image as an image showing a spatial distribution of radiation sources based on the digital communication data received from each detector module 1, and displays the radiation source distribution image on the display device 3.

FIG. 9 is a block diagram schematically showing the configuration of each detector module 1. Each detector module 1 includes a housing 11, a light receiving section 12 and a control section 13. The light receiving section 12 and the control section 13 are housed inside the housing 11.

The light receiving section 12 includes the plurality of detectors to detect ionizing radiation. In the present embodiment, at least one of the plurality of detectors contained in each detector module 1 is the scatterer detector 14, and at least one thereof is the absorber detector 15. The scatterer detector 14 is a detector functioning as a scatterer, and is formed of a material with small atomic number (e.g. silicon) to make the Compton scattering easy to occur. The scatterer detector 14 is configured in such a manner that it is possible to detect a position $X_1$ where the Compton scattering has occurred when the electromagnetic radiation enters, and energy $E_1$ acquired by a recoil electron through the Compton scattering (that is, the energy of the electromagnetic radiation lost in the scatterer detector 14 through the Compton scattering). On the other hand, the absorber detector 15 is a detector functioning as an absorber and is formed of a material with a large atomic number (e.g. CdTe and CdZnTe) to make photoelectric absorption easy to occur. The absorber detector 15 is configured in such a manner that it is possible to detect a position $X_2$ where the electromagnetic radiation has been absorbed by the absorber detector 15 through the photoelectric absorption after the Compton scattering and energy $E_2$ of the electromagnetic radiation absorbed by the absorber detector 15.

In the configuration shown in FIG. 9, the light receiving section 12 of each detector module 1 includes four scatterer detectors 14 and one absorber detector 15. However, it is possible to change the number of scatterer detectors 14 and the number of absorber detectors 15 appropriately, which are contained in the light receiving section 12. Here, the radiation measuring apparatus 10 contains at least one scatterer detector 14 and at least one absorber detector 15 as a whole.

As the scatterer detector 14, the detectors having various configurations can be used. FIG. 10A and FIG. 10B show an example of configuration of the scatterer detector 14 configured as a pixel-type detector. Here, FIG. 10A is a plan view showing the configuration of scatterer detector 14. FIG. 10B is a sectional view showing the configuration of scatterer detector 14 along the A-A section in FIG. 10A. In the configuration shown in FIG. 10A and FIG. 10B, the scatterer detector 14 includes a semiconductor layer 21, a plurality of pixel electrodes 22 arranged in a matrix on a first main surface of the semiconductor layer 21, and a common electrode 23 provided to almost cover the whole of a second main surface of the semiconductor layer 21 (the main surface opposite to the first main surface). A part of semiconductor layer 21 that is sandwiched by one of the pixel electrodes 22 and the common electrode 23 is formed as one cell to detect an electromagnetic radiation. In the measurement of the electromagnetic radiation, an analog signal corresponding to a quantity of electric charges generated in each cell is outputted from the scatterer detector 14. The semiconductor layer 21 of the scatterer detector 14 is formed of a semiconductor material for the Compton scattering to be easy to occur (i.e. having a small atomic number), e.g. silicon. For example, the pixel electrode 22 and the common electrode 23 are formed of aluminum, when the semiconductor layer 21 is formed of silicon.

FIG. 11A to FIG. 11C are diagrams showing examples of configuration having the scatterer detector 14 of a strip-type. Here, FIG. 11A is a plan view showing a configuration of the scatterer detector 14, FIG. 11B is a bottom view showing the configuration having the scatterer detector 14, and FIG. 11C is a sectional view showing the configuration having the scatterer detector 14 along the B-B plane. In the configuration having the scatterer detector 14 shown in FIG. 11A to FIG. 11C, a plurality of first strip electrodes 24 formed on the first main surface of the semiconductor layer 21 and a plurality of second strip electrodes 25 formed on the second main surface of the semiconductor layer 21 are used instead of the pixel electrodes 22 and the common electrode 23. As shown in FIG. 11A, the first strip electrodes 24 are arranged to extend in a first direction (Y axis direction in FIG. 11A), and the second strip electrodes 25 are arranged to extend a second direction (X axis direction in FIG. 11B) perpendicular to the first direction. A part of the semiconductor layer 21 sandwiched by one of the first strip electrodes 24 and one of the second strip electrodes 25 orthogonal to the first strip electrode 24 forms one cell to detect the electromagnetic radiation. When the first strip electrode 24 is used for the selection of the cell, an analog signal corresponding to a quantity of electric charges generated in each of the cells selected by use of the first strip electrode 24 is outputted from the second strip electrode 25.

The absorber detector 15 is configured in the same way as the scatterer detector 14. However, in the absorber detector 15, the semiconductor layer 21 formed of a material different from that of the scatterer detector 14 is used. More specifically, the semiconductor layer 21 of the absorber detector 15 is formed of the material in which photoelectric absorption is easy to occur (i.e. having a large atomic number), e.g. CdTe or CdZnTe.

Referring to FIG. 9 once again, the control section 13 includes ASICs (application specific integrated circuits) 16 and 17, a digital processing section 18 and a communication interface 19. The ASIC 16 operates as an analog signal processing section that reads an analog signal from each cell of the scatterer detector 14, and that carries out analog-digital conversion to the analog signal to generate digital measurement data. Each ASIC 16 includes a preamplifier 16a that operates as an integrator for integrating the analog signal read from each cell of the scatterer detector 14, and an analog-digital converter 16b that carries out analog-digital conversion to the output of the preamplifier 16a to generate the digital measurement data.

In FIG. 9, a configuration example is shown in which one ASIC 16 is provided for one scatterer detector 14. However, in case of actual implementation, each scatterer detector 14 is divided into a plurality of areas, and one ASIC 16 may be provided for each area. In this case, a plurality of ASICs 16 operate as the analog signal processing section, and each ASIC 16 carries out the analog-digital conversion to the analog signal read from the cell in a corresponding area to generate the digital measurement data.

The ASIC 17 operates an analog signal processing section that reads an analog signal from each cell of the absorber detector 15, and that carries out the analog-digital conversion to the analog signal to generate the digital measurement data. The ASIC 17 typically includes a preamplifier 17a operating as an integrator for integrating the analog signal read from each cell of the absorber detector 15 and an analog-digital converter 17b for carrying out the analog-digital conversion to the output of the preamplifier 17a to generate the digital measurement data.

In FIG. 9, the configuration is shown in which one ASIC 17 is provided for one absorber detector 15. However, in case of actual implementation, the absorber detector 15 is divided into a plurality of areas (for example, four areas), and one ASIC 17 may be provided for each area. In this case, the plurality of ASICs 17 operate as the analog signal processing section. Each ASIC 17 carries out the analog-digital conversion to the analog signal read from the cell in a corresponding area to generate the digital measurement data.

The digital processing section 18 has two functions. First, the digital processing section 18 controls the ASICs 16 and 17 to read the analog signal from the scatterer detector 14 or the absorber detector 15 at a desired timing to generate the digital measurement data. In addition, the digital processing section 18 generates digital communication data to be transmitted to the processing unit 2 from the digital measurement data received from the ASICs 16 and 17.

In one embodiment, the digital processing section 18 generates the digital communication data by settling the digital measurement data received from the ASICs 16 and 17 just as it is. The digital processing section 18 transmits the generated digital communication data to the processing unit 2 by the communication interface 19. In this case, regarding the electromagnetic radiation entered to the scatterer detector 14, the processing unit 2 specifies a position $X_1$ of occurrence of the Compton scattering, energy $E_1$ acquired by a recoil electron through the Compton scattering, a position $X_2$ of occurrence of the photoelectric absorption of the electromagnetic radiation after the scattering by the absorber detector 15, and energy $E_2$ of the electromagnetic radiation absorbed by the absorber detector 15, based on the digital measurement data contained in the received digital communication data.

In another embodiment, the digital processing section 18 may be configured to carry out a calculation to specify the position $X_1$ occurrence of the Compton scattering, the energy $E_1$ acquired by the recoil electron in the Compton scattering, a position $X_2$ of occurrence of the absorption of the electromagnetic radiation after the scattering by the absorber detector 15, and the energy $E_2$ of the electromagnetic radiation absorbed by the absorber detector 15, from the digital measurement data received from the ASICs 16 and 17. In this case, the digital processing section 18 generates the digital communication data that contains data describing the position $X_1$, the energy $E_1$, the position $X_2$ and the energy $E_2$, and transmits the generated digital communication data to the processing unit 2 by the communication interface 19.

The communication interface 19 transmits the digital communication data generated by the digital processing section 18 to the processing unit 2. Also, the communication interface 19 sends control data sent from the processing unit 2 (e.g. synchronization data to establish time synchronization among the plurality of detector modules 1) to the digital processing section 18. The communication between the communication interface 19 and the processing unit 2 may be carried out by the wired network 4 as shown in FIG. 7 and may be carried out by the radio communication as shown in FIG. 8.

FIG. 12A is a perspective view showing an example of implementation of each detector module 1. FIG. 12B and FIG. 12C are plan views showing the configuration of detector boards on which the scatterer detector 14 and the absorber detector 15 are installed, respectively. As shown in FIG. 12A, in the present embodiment, the housing 11 has a pedestal 31, and the detector boards 32 and 33 are stacked on the pedestal 31 in an order. The detector boards 32 and 33 are fixed on a desired position in the housing 11 by supporting members 34 and 35 extending to the stacking direction of the detector boards 32 and 33 from the pedestal 31. In addition, the above-mentioned digital processing section 18 and communication interface 19 are installed on the pedestal 31 (not illustrated in FIG. 12A).

As shown in FIG. 12B, each detector board 32 has a substrate 36 that loads the scatterer detector 14 and the ASIC 16 connected with the scatterer detector 14. In the present embodiment, each scatterer detector 14 is divided into four areas and four ASICs 16 are provided in correspondence to the four areas. That is, each detector board 32 is provided with one scatterer detector 14 and four ASICs 16. Each ASIC 16 is connected with a corresponding region of the scatterer detector 14 through a wiring line 37, and carries out the analog-digital conversion to the analog signal read from a cell in the corresponding region to generate the digital measurement data. Moreover, the ASIC 16 is connected with the digital processing section 18 through a wiring line 38. In the configuration shown in FIG. 12A, the number of scatterer detectors 14 contained in the light receiving section 12 of each detector module 1 is 4. Therefore, the number of detector boards 32, too, is 4.

The detector board 33 has a configuration similar to the detector board 32, excluding that the absorber detector 15 is loaded instead of the scatterer detector 14. As shown in FIG. 12C, the detector board 33 includes the substrate 39 that loads the absorber detector 15 and the ASIC 17 connected with the absorber detector 15. In the present embodiment, each absorber detector 15 is divided into four regions, and four ASICs 17 are provided in correspondence to the four regions. That is, one absorber detector 15 and the four ASICs 17 are provided for each substrate 39. Each ASIC 17 carries out the analog-digital conversion to the analog signal read from a cell in the corresponding region to generate the digital measurement data. Each ASIC 17 is connected with the corresponding cell of the absorber detector 15 through the wiring line 40, and carries out the analog-digital conversion to the analog signal read from the cell in the corresponding region to generate the digital measurement data. Moreover, the ASIC 17 is connected with the digital processing section 18 through the wiring line 41. In the configuration shown in FIG. 12A, the number of absorber detectors 15 contained in the light receiving section 12 of each detector module 1 is 1, and therefore, the number of detector boards 33, too, is 1.

In the present embodiment, by using more than one detector module 1 having the above-mentioned configuration, the electromagnetic radiation is measured, more specifically, the radiation source distribution image is generated as an image showing the spatial distribution of the radiation sources. One problem when the electromagnetic radiation is measured by using the plurality of detector modules 1 is in the establishment of synchronization among the plurality of detector modules 1. In the radiation measuring apparatus 10 of the present embodiment in which the plurality of detector modules 1 are used, there is a case that the Compton scattering of the electromagnetic radiation and the photoelectric absorption occur in different detector modules 1. In this case, it is required to determine whether the Compton scattering and the photoelectric absorption have occurred in an event for an identical photon (i.e. whether the Compton scattering and the photoelectric absorption have occurred for the identical photon of the electromagnetic radiation). For this purpose, it is necessary for the plurality of detector modules 1 to operate in synchronization with each other temporally. As described below, in the present embodiment, by making the plurality of detector modules 1 operate in synchronization with each other temporally, the radiation measuring apparatus 10 is realized so that it is possible to deal with various requests (i.e. to be applicable to various uses).

In detail, in the present embodiment, the digital processing section 18 and the processing unit 2 in each detector module 1 are configured to be able to establish the time synchronization. In detail, as shown in FIG. 9, the digital processing section 18 includes a time synchronization circuit 18a which sequentially outputs current time data showing current time. On the other hand, the processing unit 2 delivers synchronization data (e.g. the time data acquired from a system clock or a hardware clock of the processing unit 2) to each detector module 1 by the wired communication or the wireless communication. The time synchronization circuit 18a receives the synchronization data from the processing unit 2 through the communication interface 19, and generates the current time data in synchronization with the synchronization data. The digital processing section 18 controls the ASICs 16 and 17 in synchronization with the current time data and transmits to the processing unit 2, the digital communication data in which the measurement time data generated based on the current time data outputted from the time synchronization circuit 18a is involved. Here, the measurement time data is data that is generated in synchronization with the current time data (i.e. in synchronization with the synchronization data), and shows the time when the measurement of the electromagnetic radiation is carried out (that is, the time when the analog signal is inputted to the ASICs 16 and 17, as a source of the digital measurement data used for the generation of the digital communication data). Through such an operation, the synchronization of the time synchronization circuit 18a of each detector module 1 is realized, and the processing unit 2 refers to the measurement time data contained in the digital communication data to determine whether the Compton scattering which has occurred in some scatterer detector 14 and the photoelectric absorption which has occurred in some absorber detector 15 belong to the identical event.

Note that instead of transmitting the synchronization data from the processing unit 2 to each detector module 1, a signal line may be connected between each detector module 1 and the processing unit 2 to transmit a synchronization signal (e.g. a clock signal), and the time synchronization circuit 18a of each detector module 1 may operate in synchronization with the synchronization signal. In this case, the current time data and the measurement time data are generated in synchronization with the synchronization signal.

Next, the electromagnetic radiation measurement by the radiation measuring apparatus 10 of the present embodiment, more specifically, the generation of the radiation source distribution image will be described. In the following description, it is assumed that the number of scatterer detectors 14 and the number of absorber detectors 15, which are contained in each detector module 1, are same as described previously. More specifically, the description will be given on the premise of that each detector module 1 has four scatterer detectors 14 and one absorber detector 15 (note that the modification examples of the scatterer detector 14 and the absorber detector 15, which are contained in the detector module 1, will be described later).

In case of the electromagnetic radiation measurement in the present embodiment, the plurality of detector modules 1 are arranged such that the electromagnetic radiation radiated from each of radiation sources is incident on the plurality of detector modules 1. The arrangement of detector modules 1 is determined according to the nature of the radiation sources and the purpose of the measurement.

FIG. 13 to FIG. 17 are diagrams showing examples of the arrangement of the detector modules 1. As shown in FIG. 13, when the radiation source 50A that radiates the electromagnetic radiation in a high energy level is measured, the plurality of detector modules 1 are arranged such that the number of scatterer detectors 14 and the number of the absorber detectors 15, which are arranged in a layer direction are increased. More specifically, the plurality of detector modules 1 are arranges in the layer direction of the scatterer detector 14 and the absorber detector 15 (the Z axis direction in FIG. 13). According to the arrangement shown in FIG. 13, the detection sensitivity is improved to be high, in the measurement of the electromagnetic radiation in the high energy level in which the occurrence probability of the Compton scattering and the absorption probability of the photoelectric absorption are low, and the scattering angle in the Compton scattering is small.

Also, as shown in FIG. 14, when a radiation source 50B is measured that is spatially widely distributed, and that radiates the electromagnetic radiation in the low energy level, the plurality of detector modules 1 are arranged in a direction perpendicular to the layer direction of the scatterer detectors 14 and the absorber detector 15 (the Z axis direction in FIG. 14). When the electromagnetic radiation in the low energy level is measured, the number of scatterer detectors 14 and the number of absorber detectors 15 in the layer direction may be few. On the other hand, by arranging the plurality of detector modules 1 in the direction perpendicular to the layer direction of the scatterer detectors 14 and the absorber detectors 15, the effective area of the detectors that measures the electromagnetic radiation can be increased. FIG. 14 shows that the detector modules 1 are arranged along the X axis direction. However, actually, the detector modules 1 may be arranged in a matrix on a plane parallel to the XY plane.

Moreover, as shown in FIG. 15, when the radiation source 50C that radiates the electromagnetic radiation in the low energy level is measured in the high efficiency, a detector module 1 (shown as 1B in FIG. 15) may be arranged around a specific detector module 1 (shown by 1A in FIG. 15) to orient to the direction different from the orientation of the specific detector module 1. More strictly, the plurality of detector modules 1 are arranged in such a manner that a plane which a front main surface of the semiconductor layer 21 (the main surface facing the radiation source 50C) of at least one scatterer detector 14 of the specific detector module 1A intersects with the front main surface of the semiconductor layer 21 of at least one absorber detector 15 of the detector module 1B arranged around the specific detector module 1A. In the low energy electromagnetic radiation, the scattering angle $\theta$ of the Compton scattering becomes large. However, according to the arrangement shown in FIG. 15, the electromagnetic radiation scattered by the scatterer detector 14 of the detector module 1A can be efficiently detected by the absorber detector 15 of the detector module 1B arranged around the detector module 1A.

Also, as shown in FIG. 16, when the distribution of a radiation source 50D is found previously to an extent, the plurality of detector modules 1 may be arranged to surround the radiation source 50D.

Moreover, as shown in FIG. 17, when a three-dimensional radiation source distribution image of a radiation source 50E distributed three-dimensionally should be generated, the plurality of detector modules 1 may be arranged distributedly. In this case, the three-dimensional radiation source distribution image can be obtained from digital measurement data acquired from each detector modules 1 based on the principle of a stereo view.

In FIG. 13 to FIG. 17 in the above-mentioned embodiment, it is supposed that the detector modules 1 have an identical configuration. In other words, it is supposed that the number of scatterer detectors 14 and the number of absorber detectors 15, which are contained in the detector module 1 are identical among the detector modules 1 (that is, each of the detector modules 1 is supposed to have four scatterer detectors 14 and one absorber detector 15).

However, the number of scatterer detectors 14 and the number of absorber detectors 15, which are contained in the detector module 1 may differ among the detector modules 1. Also, as shown in FIG. 18A, a detector module IE, that has a plurality of scatterer detectors 14 but no absorber detector 15, may be contained in the plurality of detector modules 1 of the radiation measuring apparatus 10. Moreover, as shown in FIG. 18B, a detector module 1F, that has a plurality of absorber detectors 15 but no scatterer detector 14, may be contained in the plurality of detector modules 1 of the radiation measuring apparatus 10. Here, as a whole of the radiation measuring apparatus 10, at least one scatterer detector 14 and at least one absorber detector 15 are contained. Even if the number of scatterer detectors 14 and the number of absorber detectors 15 differ among the detector modules 1, the ionization radiation can be measured while flexibly corresponding to a difference in the nature of radiation source, if the detector modules 1 are properly arranged.

Here, as understood from FIG. 13 to FIG. 17, in the radiation measuring apparatus 10 of the present embodiment, the measurement can be carried out according to the natures of various radiation sources, even if the configuration of detector modules 1 is identical. In the viewpoint of reducing a cost of the detector module 1 while utilizing such an advantage, it is desirable that the configuration of detector modules 1 is identical.

On the other hand, as an example not forming part of the present invention, when the detector module 1E (see FIG. 18A) having a plurality of scatterer detectors 14 but no absorber detector 15 and the detector module 1F (see FIG. 18B) having a plurality of absorber detectors 15 but no scatterer detector 14 are used, there is an advantage in that a viewing angle (FOV: field of view) and an angle resolution can be controlled by controlling a distance between the detector module 1E and the detector module 1F appropriately.

FIG. 19A is a diagram showing an example of arrangement, not forming part of the present invention, of the detector modules 1 (1E, 1F) to widen the viewing angle. To widen the viewing angle, the detector modules 1E and 1F are arranged in such a manner that a distance between the detector module 1E having the scatterer detectors 14, and the detector module 1F having the absorber detectors 15 becomes small. In such an arrangement, the electromagnetic radiation can be detected even when the scattering angle $\theta$ is relatively large (for example, the scattering angles $\theta_2$, $\theta_3$ in FIG. 19A). As the result, the viewing angle can be made large. However, the angle resolution of scattering angle $\theta$ has declined in the arrangement in which the distance between the detector modules 1E and 1F is small.

On the other hand, FIG. 19B shows an example of arrangement, not forming part of the present invention, of the detector modules 1 (1E, 1F) to improve the angle resolution of scattering angle $\theta$. To improve the angle resolution, the detector modules 1E and 1F are arranged in such a manner that the distance between the detector module 1E having the scatterer detectors 14 and the detector module 1F having the absorber detectors 15 is made large. In the arrangement of the detector modules 1E and 1F having a large distance, the electromagnetic radiation cannot be detected when the scattering angle $\theta$ is relatively large (for example, the scattering angles $\theta_2$ and $\theta_3$ in FIG. 19A). However, since the scattering angle $\theta$ can be specified precisely in the arrangement shown in FIG. 19B, the angle resolution of scattering angle $\theta$ can be improved.

After each detector module 1 is arranged in a desired position, the electromagnetic radiation is measured, i.e. the radiation source distribution image showing the spatial distribution of the radiation source is generated. FIG. 20 shows a flow chart of a procedure of generation of the radiation source distribution image according to an embodiment of the present invention.

First, module arrangement data showing the arrangement of detector modules 1 is set to the processing unit 2 (Step S01). For example, as shown in FIG. 13 to FIG. 17, FIG. 19A, and FIG. 19B, in the radiation measuring apparatus 10, the arrangement of the plurality of detector modules 1 can be variously changed. However, in order to obtain a radiation source distribution image, the position of each detector module 1 (in other words, the positions of each of the scatterer detectors 14 and the absorber detector 15) needs to be informed to the processing unit 2. Step S01 is carried out to make the processing unit 2 recognize the positions of each detector modules 1.

In one embodiment, the setting of the module arrangement data may be carried out in the setting a measurement mode. In detail, a plurality of measurement modes corresponding to the arrangement of detector modules 1 are prepared, and the plurality of module arrangement data corresponding to the measurement modes are prepared. When one measurement mode is selected by the user by using a user interface of the processing unit 2, the module arrangement data corresponding to the measurement mode is selected, and is set to the processing unit 2 as the used module arrangement data used actually. A proper module arrangement data can be set to the processing unit 2 by selecting the measurement mode corresponding to the arrangement through the user interface of the processing unit 2 when the detector modules 1 are arranged in accordance with some specific arrangement.

Also, the module arrangement data showing the arrangement of detector modules 1 may be inputted to the processing unit 2. For example, the user may input the module arrangement data to the processing unit 2 by using the user interface of the processing unit 2. Also, when each detector module 1 has a function of detecting its position, each detector module 1 may detect its position, and may transmit position data showing the position to the processing unit 2. In this case, a set of the position data is set to the processing unit 2 as the module arrangement data.

Moreover, the acquisition of the digital measurement data of the electromagnetic radiation is carried out (Step S02). More specifically, an analog signal is sequentially read from the scatterer detector 14 and the absorber detector 15 by ASICs 16 and 17 of each detector module 1, and the digital measurement data corresponding to the read analog signal is generated. When the Compton scattering occurs in a cell of some scatterer detector 14, the electric charges are generated in the cell in which the Compton scattering has occurred, and the analog signal according to a quantity of the generated electric charges is generated. Also, when the photoelectric absorption occurs in a cell of some absorber detector 15, the electric charges are generated in the cell in which the photoelectric absorption has occurred, and the analog signal according to a quantity of generated electric charges is generated. The analog - digital conversion is carried out to the generated analog signal so that the digital measurement data is generated.

Moreover, data necessary to reconfigure a Compton cone is calculated (Step S03). In one embodiment, the digital measurement data generated by ASICs 16 and 17 is incorporated into the digital communication data and is sent to the processing unit 2. The processing unit 2 analyzes the digital measurement data contained in the digital communication data and carries out the following calculations:

(1) The detection of an event in which the Compton scattering of a photon has occurred in the scatterer detector 14, and then the photon to have been scattered by the Compton scattering is absorbed through the photoelectric absorption by the absorber detector 15.
(2) The calculation of the position $X_1$ of occurrence of the Compton scattering in the scatterer detector 14, the energy $E_1$ acquired by a recoil electron in the Compton scattering, the position $X_2$ of occurrence of the photoelectric absorption in the absorber detector 15, and the energy $E_2$ of the photon absorbed by the photoelectric absorption, in each event.
(3) The calculation of a scattering angle $\theta$ of the electromagnetic radiation in the Compton scattering in each event.

The calculation of the scattering angle $\theta$ of the electromagnetic radiation is carried out based on the following equation (2) or an equation equivalent to the following equation (2):

$$\cos\theta = 1 - m_e c^2 \left( \frac{1}{E_2} - \frac{1}{E_1 + E_2} \right) \qquad \cdots (2)$$

Here, $m_e$ is the electron rest mass, and c is speed of light. When the energy $E_{in}$ of a photon of the electromagnetic radiation emitted from the radiation source is already known, the energies $E_1$ and $E_2$ may be calculated by using a relation shown in the following equation (3):

$$E_{in} = E_1 + E_2 \qquad (3)$$

The Compton cones can be reconfigured for each event in which the position $X_1$ of occurrence of the Compton scattering, the energy $E_1$ of the recoil electron acquired in the Compton scattering, the position $X_2$ occurrence of the photoelectric absorption, the energy $E_2$ of the photon absorbed in the photoelectric absorption, and the scattering angle $\theta$ of the electromagnetic radiation are obtained in this way.

In the detection of an event of occurrence of the Compton scattering in the scatterer detector 14 and of occurrence of the photoelectric absorption of the photon scattered in the Compton scattering by the absorber detector 15, it is required to determine whether some Compton scattering and some photoelectric absorption have occurred to an identical photon. Note that in the radiation measuring apparatus 10 in the present embodiment, there is a case where the detector module 1 (the first detector module) to which the scatterer detector 14 belongs, in which the Compton scattering has occurred, is different from the detector module (the second detector module) to which the absorber detector 15 belongs, in which the photoelectric absorption of the photon scattered in the Compton scattering has occurred, for example, as shown in FIG. 13, FIG. 15, FIG. 19A, and FIG. 19B. It is desirable to properly determine that the Compton scattering and the photoelectric absorption belong to the identical event, even if the Compton scattering and the photoelectric absorption have occurred in different detector modules 1.

To cope with this problem, in one embodiment, the determination of whether some Compton scattering and some photoelectric absorption belong to an event to the identical photon may be carried out based on measurement time data contained in digital communication data. The occurrence of the Compton scattering and the occurrence of the photoelectric absorption can be considered to be substantially approximately simultaneous (i.e. in the comparison with a time necessary for analog signal processing and digital data processing). In one embodiment, when the measurement time data detected in the occurrence of the Compton scattering and contained in the digital measurement data and the measurement time data detected in the occurrence of the photoelectric absorption and contained in the digital measurement data are identical to each other (or, the difference between times shown in the measurement time data is smaller than a predetermined time which is an extremely short time), the processing unit 2 may determine that the Compton scattering and the photoelectric absorption belong to an event which has occurred to an identical photon, even if the detector module 1 to which the scatterer detector 14 belongs, in which the occurrence of the Compton scattering is detected, is different from the detector module 1 to which the absorber detector 15 belongs, in which the occurrence of the photoelectric absorption is detected.

In the determination of whether some Compton scattering and some photoelectric absorption belong to an event to the identical photon, the arrangement of the detector modules 1 shown in the module arrangement data may be referred to, in addition to the measurement time data contained in the digital communication data. For example, when the scatterer detector 14 in which the Compton scattering has occurred and the absorber detector 15 in which the photoelectric absorption has occurred are contained in different detector modules 1, the processing unit 2 may determine that the Compton scattering and the photoelectric absorption belong the event to the identical photon, if the different detector modules 1 are arranged to be close to each other, and the time shown in the measurement time data contained in the digital measurement data upon the detection of occurrence of the Compton scattering and the time shown in the measurement time data contained in the digital measurement data upon the detection of occurrence of the photoelectric absorption are identical to each other (or, a difference between the times shown in the measurement time data is smaller than a predetermined time that is an extremely short time). However, when a plurality of detector modules 1 are collectively arranged, the processing unit 2 may determine that the Compton scattering and the photoelectric absorption belong to an event to the identical photon, with no relation to the module arrangement data, if the time shown in the measurement time data contained in the digital measurement data upon the detection of occurrence of the Compton scattering and the time shown in the measurement time data contained in the digital measurement data upon the detection of occurrence of the photoelectric absorption are identical to each other (or, the difference between the times shown in the measurement time data is smaller than a predetermined time that is an extremely short time).

Also, the calculation of the position $X_1$ of the occurrence of the Compton scattering in the scatterer detector 14, the energy $E_1$ of a recoil electron acquired in the Compton scattering, the position $X_2$ of occurrence of the photoelectric absorption in the absorber detector 15, and the energy $E_2$ of the photon absorbed through the photoelectric absorption may be carried out by the digital processing section 18 of each detector module 1. In this case, the digital communication data is generated by the digital processing section 18 to contain the position $X_1$ of occurrence of the Compton scattering, the energy $E_1$ of the recoil electron acquired in the Compton scattering, the position $X_2$ occurrence of the photoelectric absorption, the energy $E_2$ of the photon absorbed through the photoelectric absorption, and the measurement time data. The digital communication data is transmitted to the processing unit 2. Such a configuration is effective for the purpose of the reduction of traffic of the digital communication data. The reduction of traffic of the digital communication data is useful in case of the transmission of the digital communication data to the processing unit 2 by using a wired network 4, or in case of transmission of the digital communication data to the processing unit 2 by using a wireless LAN.

In this case, the processing unit 2 detects the occurrence of an event, in which the Compton scattering has occurred in the scatterer detector 14, and the photon scattered in the Compton scattering is absorbed by the absorber detector 15 through the photoelectric absorption, based on the measurement time data contained in the digital communication data. Moreover, the processing unit 2 calculates the scattering angle θ of electromagnetic radiation in the Compton scattering for each event. The data for each event can be obtained from the digital communication data transmitted to the processing unit 2, that is, the position $X_1$ of occurrence of the Compton scattering, the energy $E_1$ of the recoil electron acquired in the Compton scattering, the position $X_2$ of occurrence of the photoelectric absorption, and the energy $E_2$ of the photon absorbed through the photoelectric absorption can be obtained. Therefore, in case of calculation of the scattering angle θ of electromagnetic radiation for each event, these data are used. Compton cones can be reconfigured for each event, from the position $X_1$ of occurrence of the Compton scattering, the energy $E_1$ of the recoil electron acquired in the Compton scattering, the position $X_2$ of occurrence of the photoelectric absorption, the energy $E_2$ of the photon absorbed through the photoelectric absorption, and the scattering angle θ of electromagnetic radiation, which are obtained as described above.

Moreover, the processing unit 2 generates a radiation source distribution image showing a spatial distribution of radiation sources based on data obtained at step S03 (for example, positions $X_1$ and $X_2$, energies $E_1$ and $E_2$, and scattering angle θ) (Step S04). In detail, the processing unit 2 reconfigures the Compton cones for each event from the position $X_1$ of occurrence of the Compton scattering, the energy $E_1$ of the recoil electron acquired in the Compton scattering, the position $X_2$ of occurrence of the photoelectric absorption, the energy $E_2$ of the photon absorbed through the photoelectric absorption, and the scattering angle θ of electromagnetic radiation. Moreover, the processing unit 2 generates an image corresponding to overlaying of the reconfigured Compton cones as a radiation source distribution image showing a spatial distribution of radiation sources 103. The generated radiation source distribution image is displayed on the display device 3 according to an operation to the user interface of the processing unit 2 by the user.

As shown in FIG. 17, when the detector modules 1 are distributedly arranged to obtain a three-dimensional radiation source distribution image based on the principle of stereo view, the processing unit 2 may reconfigure the Compton cones individually for the detector modules 1 from the digital measurement data obtained in the detector modules 1, and the three-dimensional radiation source distribution image may be generated from the reconfigured Compton cones and the module arrangement data based on the principle of stereo view. In other words, the processing unit 2 may specify the position of each radiation source from the module arrangement data and the Compton cones reconfigured individually for each detector module 1 based on the principle of stereo view. In this case, the processing unit 2 may calculate a source intensity of each radiation source based on the position of specified radiation source.

One advantage of the radiation measuring apparatus 10 in the present embodiment described above is in that the ionization radiation can be measured while flexibly dealing with the difference in the nature of the radiation source and the purpose of measurement. The radiation measuring apparatus 10 in the present embodiment contains the plurality of detector modules 1. If the arrangement of the detector modules 1 is determined according to the nature of the radiation source and the purpose of measurement, for example, as shown in FIG. 13 to FIG. 17, FIG. 19A, and FIG. 19B, the radiation measuring apparatus 10 of the present embodiment can measure the ionization radiation while flexibly dealing with the difference in the nature of the radiation source.

Here, in the radiation measuring apparatus 10 in the present embodiment, it is desirable that the relative position relation among the detector modules 1 is surely maintained during the measurement of the electromagnetic radiation. When the relative position relation among the detector modules 1 changes during the measurement of the electromagnetic radiation, it becomes impossible to correctly specify the position of occurrence of the Compton scattering and the position of occurrence of the photoelectric absorption.

In order to surely maintain the relative position relation among the detector modules 1, it is desirable that a connection mechanism is provided for the housing 11 of each detector module 1 to connect to the housing 11 of the other detector module 1. FIG. 21A is a diagram showing the detector module 1 of such a configuration. As shown in FIG. 21A, the connection mechanism 11a is provided for the housing 11 of each detector module 1. The housing 11 of a neighbor detector module 1 is connected by the connection mechanism 11a. In FIG. 21A, the detector modules 1 are connected to a direction of layers (the Z axial direction in FIG. 20A) of the scatterer detector 14 and the absorber detector 15 by the connection mechanism 11a. By using the connection mechanism 11a, the relative position relation among the detector modules 1 can be surely maintained.

It is desirable that the connection mechanism 11a provided for the housing 11 is configured to be able to connect the neighbor detector module 1 to both of the direction of layer (the Z axis direction of FIG. 21A) of the scatterer detector 14 and the absorber detector 15 and a direction perpendicular to the direction of layer (the X axis direction of FIG. 21A). FIG. 21B is a diagram conceptually showing the detector modules 1 arranged and connected in the direction perpendicular to the direction of layer of the scatterer detector 14 and the absorber detector 15 by the connection mechanism 11a. FIG. 21B shows the detector modules 1 so as to be arranged in the X axis direction. However, actually, the detector modules 1 may be arranged and connected on a plane parallel to the XY plane.

Various embodiments of the present invention have been described. However, the present invention is not limited to the above-mentioned embodiments. It would be apparent to a skilled person that the present invention can be implemented with various changes, as long as they fall within the scope of the invention as defined by the appended claims.

**Claims**

1. A radiation measuring apparatus (10) comprising:

   a plurality of detector modules (1); and
   a processing unit (2),
   wherein each of the plurality of detector modules (1) comprises:

   at least one scatterer detector (14) functioning as a scatterer scattering electromagnetic radiation;
   at least one absorber detector (15) functioning as an absorber absorbing electromagnetic radiation;
   a plurality of analog signal processing sections (16b, 17b), each of which is provided for a corresponding one of the at least one scatterer detector (14) and the at least one absorber detector (15) to carry out analog-digital conversion to an analog signal obtained from the corresponding detector to generate digital measurement data corresponding to the analog signal; and
   a digital processing section (18) configured to:

   carry out a calculation to specify a scattering position of Compton scattering in the at least one scatterer detector (14) and a first energy given to a recoil electron in the Compton scattering based on the digital measurement data;
   carry out a calculation to specify an absorption position of photoelectric absorption in the at least one absorber detector (15) and a second energy absorbed by the photoelectric absorption based on the digital measurement data;
   generate digital communication data containing the scattering position, the first energy, the absorption position, and the second energy from the digital measurement data; and
   transmit the digital communication data to the processing unit (2); and

   a housing (11) inside which the at least one scatterer detector (14), the at least one absorber detector (15), the plurality of analog signal processing sections (16b, 17b), and the digital processing section (18) are housed, and
   wherein the processing unit (2) is outside of the housing (11), and
   wherein the processing unit (2) is configured to generate a radiation source distribution image showing a spatial distribution of radiation sources based on the digital communication data, and
   wherein the processing unit (2) is further configured to:

   detect, based on the digital communication data, an event in which Compton scattering has occurred in the scatterer detector (14) of a first detector module of the plurality of detector modules (1) and photoelectric absorption of a photon scattered in the Compton scattering has occurred in the absorber detector (15) of a second detector module of the plurality of detector modules (1), the second detector module being different from the first detector module;
   reconfigure a Compton cone corresponding to the detected event based on the scattering position, the first energy, the absorption position, and the second energy which are contained in the digital communication data; and
   generate the radiation source distribution image based on the Compton cone.

2. The radiation measuring apparatus (10) according to claim 1, wherein the processing unit (2) is configured to supply a synchronization data or a synchronization signal to each of the plurality of detector modules (1),

   wherein each of the plurality of detector modules (1) is configured to generate the digital communication data to contain measurement time data generated in synchronization with the synchronization data or the synchronization signal, and
   wherein the processing unit (2) is configured to detect, based on the measurement time data, occurrence of the event in which the Compton scattering occurs in the scatterer detector (14) of the first detector module, and in which the photoelectric absorption of the photon scattered in the Compton scattering occurs in the absorber detector (15) of the second detector module.

3. The radiation measuring apparatus (10) according to claim 1 or 2, wherein the number of scatterer detectors (14) is identical over the plurality of detector modules (1), and
   wherein the number of absorber detectors (15) is identical over the plurality of detector modules (1).

4.  The radiation measuring apparatus (10) according to claim 3, wherein the plurality of detector modules (1) have an identical configuration.

5.  The radiation measuring apparatus (10) according to any one of claims 1 to 4, wherein the digital processing section (18) of each of the plurality of detector modules (1) transmits the digital communication data to the processing unit (2) by a wireless communication.

6.  The radiation measuring apparatus (10) according to any one of claims 1 to 5, wherein each of the plurality of detector modules (1) comprises a housing (11) configured to accommodate the at least one scatterer detector (14) and the at least one absorber detector (15), the plurality of analog signal processing sections (16b, 17b), and the digital processing section (18), and
    wherein the housing (11) of each of the plurality of detector modules (1) has a coupling mechanism to connect the housing (11) of another of the plurality of detector modules (1) .

7.  A radiation measuring method using a radiation measuring apparatus (10) that comprises a processing unit (2) and a plurality of detector modules (1), each of which comprises:

    at least one scatterer detector (14) functioning as a scatterer scattering electromagnetic radiation;
    at least one absorber detector (15) functioning as an absorber absorbing electromagnetic radiation;
    a digital processing section (18); and
    a housing (11) inside which the at least one scatterer detector (14), the at least one absorber detector (15), and the digital processing section (18) are housed, the processing unit (2) being outside of the housing (11),
    the radiation measuring method comprising:

    arranging the plurality of detector modules (1);
    generating, by each of the plurality of detector modules (1), digital measurement data corresponding to an analog signal obtained from each of the at least one scatterer detector (14) and the at least one absorber detector (15) by carrying out analog-digital conversion to the analog signal;
    carrying out, by the digital processing section (18) of each of the plurality of detector modules (1), a calculation to specify a scattering position of Compton scattering in the at least one scatterer detector (14) and a first energy given to a recoil electron in the Compton scattering based on the digital measurement data;
    carrying out, by the digital processing section (18) of each of the plurality of detector modules (1), a calculation to specify an absorption position of photoelectric absorption in the at least one absorber detector (15) and a second energy absorbed by the photoelectric absorption based on the digital measurement data;
    generating, by the digital processing section (18) of each of the plurality of detector modules (1), digital communication data from the digital measurement data, the digital communication data containing the scattering position, the first energy, the absorption position, and the second energy;
    transmitting the digital communication data to the processing unit (2); and
    generating, by the processing unit (2), a radiation source distribution image showing a spatial distribution of the radiation source based on the digital communication data,
    wherein the generating the radiation source distribution image comprises:

    detecting, based on the digital communication data, an event in which Compton scattering has occurred in the scatterer detector (14) of a first detector module of the plurality of detector modules (1) and photoelectric absorption of a photon scattered in the Compton scattering has occurred in the absorber detector (15) of a second detector module of the plurality of detector modules (1), the second detector module being different from the first detector module;
    reconfiguring, by the processing unit (2), a Compton cone corresponding to the detected event based on the scattering position, the first energy, the absorption position, and the second energy which are contained in the digital communication data; and
    generating the radiation source distribution image based on the Compton cone.

**Patentansprüche**

1.  Eine Strahlungsmessvorrichtung (10), aufweisend:

    eine Vielzahl von Detektormodulen (1); und

eine Verarbeitungseinheit (2),
wobei jedes der Vielzahl von Detektormodulen (1) aufweist:

mindestens einen Streudetektor (14), der als ein Streuer fungiert, der elektromagnetische Strahlung streut;
mindestens einen Absorberdetektor (15), der als ein Absorber fungiert, der elektromagnetische Strahlung absorbiert;
eine Vielzahl von analogen Signalverarbeitungsabschnitten (16b, 17b), von denen jeder für einen korrespondierenden von dem mindestens einen Streudetektor (14) und dem mindestens einen Absorberdetektor (15) vorgesehen ist, um eine Analog-Digital-Wandlung eines von dem korrespondierenden Detektor erhaltenen analogen Signals auszuführen, um digitale Messdaten korrespondierend zu dem analogen Signal zu erzeugen; und
einen digitalen Verarbeitungsabschnitt (18), der konfiguriert ist, um:

eine Berechnung auszuführen, um eine Streuposition einer Compton-Streuung in dem mindestens einen Streudetektor (14) und eine erste Energie, die einem Rückstoßelektron bei der Compton-Streuung gegeben wird, basierend auf den digitalen Messdaten zu spezifizieren;
eine Berechnung auszuführen, um eine Absorptionsposition einer photoelektrischen Absorption in dem mindestens einen Absorberdetektor (15) und eine zweite Energie, die durch die photoelektrische Absorption absorbiert wird, basierend auf den digitalen Messdaten zu spezifizieren;
digitale Kommunikationsdaten, die die Streuposition, die erste Energie, die Absorptionsposition und die zweite Energie enthalten, aus den digitalen Messdaten zu erzeugen; und
die digitalen Kommunikationsdaten an die Verarbeitungseinheit (2) zu übertragen; und

ein Gehäuse (11), in dem der mindestens eine Streudetektor (14), der mindestens eine Absorberdetektor (15), die Vielzahl von analogen Signalverarbeitungsabschnitten (16b, 17b) und der digitale Verarbeitungsabschnitt (18) untergebracht sind, und
wobei sich die Verarbeitungseinheit (2) außerhalb des Gehäuses (11) befindet, und
wobei die Verarbeitungseinheit (2) konfiguriert ist, um ein Strahlungsquellenverteilungsbild, das eine räumliche Verteilung von Strahlungsquellen zeigt, basierend auf den digitalen Kommunikationsdaten zu erzeugen, und
wobei die Verarbeitungseinheit (2) ferner konfiguriert ist, um:

basierend auf den digitalen Kommunikationsdaten ein Ereignis zu erfassen, bei dem eine Compton-Streuung in dem Streudetektor (14) eines ersten Detektormoduls der Vielzahl von Detektormodulen (1) aufgetreten ist, und eine photoelektrische Absorption eines in der Compton-Streuung gestreuten Photons in dem Absorberdetektor (15) eines zweiten Detektormoduls der Vielzahl von Detektormodulen (1) aufgetreten ist, wobei sich das zweite Detektormodul von dem ersten Detektormodul unterscheidet;
einen Compton-Kegel korrespondierend zu dem erfassten Ereignis basierend auf der Streuposition, der ersten Energie, der Absorptionsposition und der zweiten Energie, die in den digitalen Kommunikationsdaten enthalten sind, zu rekonfigurieren; und
das Strahlungsquellenverteilungsbild basierend auf dem Compton-Kegel zu erzeugen.

2. Die Strahlungsmessvorrichtung (10) nach Anspruch 1, wobei die Verarbeitungseinheit (2) konfiguriert ist, um jedem der Vielzahl von Detektormodulen (1) Synchronisationsdaten oder ein Synchronisationssignal zuzuführen,

wobei jedes der Vielzahl von Detektormodulen (1) konfiguriert ist, um die digitalen Kommunikationsdaten zu erzeugen, um Messzeitdaten zu enthalten, die synchron mit den Synchronisationsdaten oder dem Synchronisationssignal erzeugt werden, und
wobei die Verarbeitungseinheit (2) konfiguriert ist, um basierend auf den Messzeitdaten ein Auftreten des Ereignisses zu erfassen, bei dem die Compton-Streuung in dem Streudetektor (14) des ersten Detektormoduls auftritt, und bei dem die photoelektrische Absorption des bei der Compton-Streuung gestreuten Photons in dem Absorberdetektor (15) des zweiten Detektormoduls auftritt.

3. Die Strahlungsmessvorrichtung (10) nach Anspruch 1 oder 2, wobei die Anzahl an Streudetektoren (14) über die Vielzahl von Detektormodulen (1) identisch ist, und
wobei die Anzahl an Absorberdetektoren (15) über die Vielzahl von Detektormodulen (1) identisch ist.

4. Die Strahlungsmessvorrichtung (10) nach Anspruch 3, wobei die Vielzahl von Detektormodulen (1) eine identische Konfiguration aufweist.

5. Die Strahlungsmessvorrichtung (10) nach einem der Ansprüche 1 bis 4, wobei der digitale Verarbeitungsabschnitt (18) jedes der Vielzahl von Detektormodulen (1) die digitalen Kommunikationsdaten durch eine drahtlose Kommunikation an die Verarbeitungseinheit (2) überträgt.

6. Die Strahlungsmessvorrichtung (10) nach einem der Ansprüche 1 bis 5, wobei jedes der Vielzahl von Detektormodulen (1) ein Gehäuse (11) aufweist, das konfiguriert ist, um den mindestens einen Streudetektor (14) und den mindestens einen Absorberdetektor (15), die Vielzahl von analogen Signalverarbeitungsabschnitten (16b, 17b) und den digitalen Verarbeitungsabschnitt (18) aufzunehmen, und
wobei das Gehäuse (11) jedes der Vielzahl von Detektormodulen (1) einen Kopplungsmechanismus aufweist, um das Gehäuse (11) eines anderen der Vielzahl von Detektormodulen (1) zu verbinden.

7. Ein Strahlungsmessverfahren unter Verwendung einer Strahlungsmessvorrichtung (10), die eine Verarbeitungseinheit (2) und eine Vielzahl von Detektormodulen (1) aufweist, von denen jedes aufweist:

mindestens einen Streudetektor (14), der als ein Streuer fungiert, der elektromagnetische Strahlung streut;
mindestens einen Absorberdetektor (15), der als ein Absorber fungiert, der elektromagnetische Strahlung absorbiert;
einen digitalen Verarbeitungsabschnitt (18); und
ein Gehäuse (11), in dem der mindestens eine Streudetektor (14), der mindestens eine Absorberdetektor (15) und der digitale Verarbeitungsabschnitt (18) untergebracht sind, wobei sich die Verarbeitungseinheit (2) außerhalb des Gehäuses (11) befindet,
das Strahlungsmessverfahren aufweist:

Anordnen der Vielzahl von Detektormodulen (1);
Erzeugen von digitalen Messdaten durch jedes der Vielzahl von Detektormodulen (1) korrespondierend zu einem analogen Signal, das von jedem des mindestens einen Streudetektors (14) und des mindestens einen Absorberdetektors (15) erhalten wird, indem eine Analog-Digital-Wandlung des analogen Signals ausgeführt wird;
Ausführen einer Berechnung durch den digitalen Verarbeitungsabschnitt (18) jedes der Vielzahl von Detektormodulen (1), um eine Streuposition einer Compton-Streuung in dem mindestens einen Streudetektor (14) und eine erste Energie, die einem Rückstoßelektron bei der Compton-Streuung gegeben wird, basierend auf den digitalen Messdaten zu spezifizieren;
Ausführen einer Berechnung durch den digitalen Verarbeitungsabschnitt (18) jedes der Vielzahl von Detektormodulen (1), um eine Absorptionsposition einer photoelektrischen Absorption in dem mindestens einen Absorberdetektor (15) und eine zweite durch die photoelektrische Absorption absorbierte Energie basierend auf den digitalen Messdaten zu spezifizieren;
Erzeugen, durch den digitalen Verarbeitungsabschnitt (18) jedes der Vielzahl von Detektormodulen (1), von digitalen Kommunikationsdaten aus den digitalen Messdaten, wobei die digitalen Kommunikationsdaten die Streuposition, die erste Energie, die Absorptionsposition und die zweite Energie enthalten;
Übertragen der digitalen Kommunikationsdaten an die Verarbeitungseinheit (2); und
Erzeugen, durch die Verarbeitungseinheit (2), eines Strahlungsquellenverteilungsbildes, das eine räumliche Verteilung der Strahlungsquelle zeigt, basierend auf den digitalen Kommunikationsdaten,

wobei das Erzeugen des Strahlungsquellenverteilungsbildes aufweist:

Erfassen, basierend auf den digitalen Kommunikationsdaten, eines Ereignisses, bei dem eine Compton-Streuung in dem Streudetektor (14) eines ersten Detektormoduls der Vielzahl von Detektormodulen (1) aufgetreten ist, und eine photoelektrische Absorption eines bei der Compton-Streuung gestreuten Photons in dem Absorberdetektor (15) eines zweiten Detektormoduls der Vielzahl von Detektormodulen (1) aufgetreten ist, wobei sich das zweite Detektormodul von dem ersten Detektormodul unterscheidet;
Rekonfigurieren, durch die Verarbeitungseinheit (2), eines Compton-Kegels, der zu dem erfassten Ereignis korrespondiert, basierend auf der Streuposition, der ersten Energie, der Absorptionsposition und der zweiten Energie, die in den digitalen Kommunikationsdaten enthalten sind; und
Erzeugen des Strahlungsquellenverteilungsbildes basierend auf dem Compton-Kegel.

**Revendications**

1. Appareil de mesure de rayonnement (10) comprenant :

> une pluralité de modules de détecteur (1) ; et
> une unité de traitement (2),
> dans lequel chacun de la pluralité de modules de détecteur (1) comprend :
>
>> au moins un détecteur diffuseur (14) fonctionnant comme un diffuseur diffusant un rayonnement électromagnétique ;
>> au moins un détecteur absorbeur (15) fonctionnant comme un absorbeur absorbant un rayonnement électromagnétique ;
>> une pluralité de sections de traitement de signal analogique (16b, 17b), chacune étant fournie pour un correspondant parmi le au moins un détecteur diffuseur (14) et le au moins un détecteur absorbeur (15) pour effectuer une conversion analogique-numérique sur un signal analogique obtenu à partir du détecteur correspondant pour générer des données de mesure numériques correspondant au signal analogique ; et
>>
>> une section de traitement numérique (18) configurée pour :
>>
>>> effectuer un calcul pour spécifier une position de diffusion d'une diffusion Compton dans le au moins un détecteur diffuseur (14) et une première énergie donnée à un électron de recul dans la diffusion Compton sur la base des données de mesure numériques ;
>>> effectuer un calcul pour spécifier une position d'absorption d'une absorption photoélectrique dans le au moins un détecteur absorbeur (15) et une deuxième énergie absorbée par l'absorption photoélectrique sur la base des données de mesure numériques ;
>>> générer des donnés de communication numériques contenant la position de diffusion, la première énergie, la position d'absorption, et la deuxième énergie à partir des données de mesure numériques ; et
>>> transmettre les données de communication numériques à l'unité de traitement (2) ; et
>>> un boîtier (11) à l'intérieur duquel le au moins un détecteur diffuseur (14), le au moins un détecteur absorbeur (15), la pluralité de sections de traitement de signal analogique (16b, 17b), et la section de traitement numérique (18) sont logés, et
>>> dans lequel l'unité de traitement (2) est hors du boîtier (11), et
>>> dans lequel l'unité de traitement (2) est configurée pour générer une image de distribution de source de rayonnement montrant une distribution spatiale de sources de rayonnement sur la base des données de communication numériques, et
>>
>> dans lequel l'unité de traitement (2) est configurée en outre pour :
>>
>>> détecter, sur la base des données de communication numériques, un événement dans lequel une diffusion Compton s'est produite dans le détecteur diffuseur (14) d'un premier module de détecteur de la pluralité de modules de détecteur (1) et une absorption photoélectrique d'un photon diffusé lors de la diffusion Compton s'est produite dans le détecteur absorbeur (15) d'un deuxième module de détecteur de la pluralité de modules de détecteur (1), le deuxième module de détecteur étant différent du premier module de détecteur ;
>>> reconfigurer un cône Compton correspondant à l'événement détecté sur la base de la position de diffusion, de la première énergie, de la position d'absorption, et de la deuxième énergie qui sont contenues dans les données de communication numériques ; et
>>> générer l'image de distribution de source de rayonnement sur la base du cône Compton.

2. Appareil de mesure de rayonnement (10) selon la revendication 1, dans lequel l'unité de traitement (2) est configurée pour fournir des données de synchronisation ou un signal de synchronisation à chacun de la pluralité de modules de détecteur (1),

> dans lequel chacun de la pluralité de modules de détecteur (1) est configuré pour générer les données de communication numériques pour contenir des données de temps de mesure générées en synchronisation avec les données de synchronisation ou le signal de synchronisation, et
> dans lequel l'unité de traitement (2) est configurée pour détecter, sur la base des données de temps de mesure, l'occurrence de l'événement dans lequel la diffusion Compton se produit dans le détecteur diffuseur (14) du premier module de détecteur, et dans lequel l'absorption photoélectrique du photon diffusé dans la diffusion Compton se produit dans le détecteur absorbeur (15) du deuxième module de détecteur.

3. Appareil de mesure de rayonnement (10) selon la revendication 1 ou 2, dans lequel le nombre de détecteurs diffuseurs (14) est identique par rapport à la pluralité de modules de détecteur (1), et
dans lequel le nombre de détecteurs absorbeurs (15) est identique par rapport à la pluralité de modules de détecteur (1).

4. Appareil de mesure de rayonnement (10) selon la revendication 3, dans lequel la pluralité de modules de détecteur (1) présentent une configuration identique.

5. Appareil de mesure de rayonnement (10) selon l'une quelconque des revendications 1 à 4, dans lequel la section de traitement numérique (18) de chacun de la pluralité de modules de détecteur (1) transmet les données de communication numériques à l'unité de traitement (2) par une communication sans fil.

6. Appareil de mesure de rayonnement (10) selon l'une quelconque des revendications 1 à 5, dans lequel chacun de la pluralité de modules de détecteur (1) comprend un boîtier (11) configuré pour loger le au moins un détecteur diffuseur (14) et le au moins un détecteur absorbeur (15), la pluralité de sections de traitement de signal analogique (16b, 17b), et la section de traitement numérique (18), et
dans lequel le boîtier (11) de chacun de la pluralité de modules de détecteur (1) présente un mécanisme de couplage pour connecter le boîtier (11) d'un autre de la pluralité de modules de détecteur (1).

7. Procédé de mesure de rayonnement utilisant un appareil de mesure de rayonnement (10) qui comprend une unité de traitement (2) et une pluralité de modules de détecteur (1), chacun comprenant :

au moins un détecteur diffuseur (14) fonctionnant comme un diffuseur diffusant un rayonnement électromagnétique ;
au moins un détecteur absorbeur (15) fonctionnant comme un absorbeur absorbant un rayonnement électromagnétique ;
une section de traitement numérique (18) ; et
un boîtier (11) à l'intérieur duquel le au moins un détecteur diffuseur (14), le au moins un détecteur absorbeur (15), et la section de traitement numérique (18) sont logés, l'unité de traitement (2) se trouvant hors du boîtier (11),
le procédé de mesure de rayonnement comprenant :

l'agencement de la pluralité de modules de détecteur (1) ;
la génération, par chacun de la pluralité de modules de détecteur (1), des données de mesure numériques correspondant à un signal analogique obtenu à partir de chacun parmi le au moins un détecteur diffuseur (14) et le au moins un détecteur absorbeur (15) en effectuant une conversion analogique-numérique sur le signal analogique ;
la mise en oeuvre, par la section de traitement numérique (18) de chacun de la pluralité de modules de détecteur (1), d'un calcul pour spécifier une position de diffusion d'une diffusion Compton dans le au moins un détecteur diffuseur (14) et une première énergie donnée à un électron de recul dans la diffusion Compton sur la base des données de mesure numériques ;
la mise en oeuvre, par la section de traitement numérique (18) de chacun de la pluralité de modules de détecteur (1), d'un calcul pour spécifier une position d'absorption d'une absorption photoélectrique dans le au moins un détecteur absorbeur (15) et une deuxième énergie absorbée par l'absorption photoélectrique sur la base des données de mesure numériques ;
la génération, par la section de traitement numérique (18) de chacun de la pluralité de modules de détecteur (1), de données de communication numériques à partir des données de mesure numériques, des donnés de communication numériques contenant la position de diffusion, la première énergie, la position d'absorption, et la deuxième énergie ;
la transmission des données de communication numériques à l'unité de traitement (2) ; et
la génération, par l'unité de traitement (2), d'une image de distribution de source de rayonnement montrant une distribution spatiale de la source de rayonnement sur la base des données de communication numériques,

dans lequel la génération de l'image de distribution de source de rayonnement comprend :

la détection, sur la base des données de communication numériques, d'un événement dans lequel une diffusion Compton s'est produite dans le détecteur diffuseur (14) d'un premier module de détecteur de la pluralité de modules de détecteur (1) et une absorption photoélectrique d'un photon diffusé lors de la diffusion Compton s'est produite dans le détecteur absorbeur (15) d'un deuxième module de détecteur de la pluralité de modules de détecteur (1), le deuxième module de détecteur étant différent du premier module de détecteur ;

la reconfiguration, par l'unité de traitement (2), d'un cône Compton correspondant à l'événement détecté sur la base de la position de diffusion, de la première énergie, de la position d'absorption, et de la deuxième énergie qui sont contenues dans les données de communication numériques ; et

la génération de l'image de distribution de source de rayonnement sur la base du cône Compton.

# Fig. 1

☼—103:RADIATION SOURCE (Ein)

COMPTON
SCATTERING(E$_1$, X$_1$)

PHOTOELECTRIC
ABSORPTION(E$_2$, X$_2$)

θ

101
101
101
101
102
102

104

# Fig. 2

ELECTROMAGNETIC RADIATION
(X-RAY, GAMMA RAY)

100

101:SCATTERER
DETECTOR

101
101

102:ABSORBER 101
DETECTOR

102

Fig. 3

ELECTROMAGNETIC RADIATION
(X-RAY, GAMMA RAY)

100

101
101
101

102
102
102

Fig. 4

ELECTROMAGNETIC RADIATION
(X-RAY, GAMMA RAY)

100

101

101

102

102

102

# Fig. 5

ELECTROMAGNETIC RADIATION
(X-RAY, GAMMA RAY)

# Fig. 6

ELECTROMAGNETIC RADIATION
(X-RAY, GAMMA RAY)

## Fig.7

```
┌─────────┐
│ ┌─────┐ │ ~3                    ~10
│ │     │ │
│ └─────┘ │
└────┬────┘
┌────┴────┐
│PROCESSING│ ~2
│  UNIT   │
└────┬────┘
     │                              4
─────┼──────┬─────────┬─────────┬──────────
  ┌──┴──┐ ┌─┴───┐  ┌──┴──┐  ┌───┴──┐
  │DETECTOR│ │DETECTOR│ │DETECTOR│ │DETECTOR│
  │MODULE│ │MODULE│  │MODULE│  │MODULE│
  └──────┘ └──────┘  └──────┘  └──────┘
     1       1          1         1
```

## Fig.8

```
┌─────────┐
│ ┌─────┐ │ ~3                    ~10
│ │     │ │
│ └─────┘ │
└────┬────┘
┌────┴────┐
│PROCESSING│ ~2
│  UNIT   │
└─────────┘
   ⚡  ⚡     ⚡      ⚡
  ┌──────┐ ┌──────┐ ┌──────┐ ┌──────┐
  │DETECTOR│ │DETECTOR│ │DETECTOR│ │DETECTOR│
  │MODULE│ │MODULE│  │MODULE│  │MODULE│
  └──────┘ └──────┘  └──────┘  └──────┘
     1       1          1         1
```

# Fig. 9

ELECTROMAGNETIC RADIATION
(X-RAY, GAMMA RAY)

12:LIGHT RECEIVING SECTION

11:HOUSING

13:CONTROL SECTION

1

14:SCATTERER DETECTOR

16a  16b

16:ASIC

18

14

16

DIGITAL PROCESSING SECTION

19

14

16

COMMUNI-CATION I/F

TO PROCESSING UNIT 2

14

TIME SYNCHRO-NIZATION

15:ABSORBER DETECTOR

16

17:ASIC

18a

17a  17b

Z
Y⊗ → X

EP 3 282 288 B1

# Fig. 10A

14(15)

21

22 22 22

A ――――――――――――――――――― A

Y

Z ⊙ → X

# Fig. 10B

A-A

14(15)

22 22 22

21

23

Z

Y ⊗ → X

# F i g . 1 1 A

# F i g . 1 1 B

# F i g . 1 1 C

# Fig. 12A

# Fig. 12B

Fig. 12C

Fig. 13

50A:RADIATION SOURCE

12:LIGHT RECEIVING
SECTION

14
14
14
14
15

1

13:CONTROL
SECTION

12

1

13

12

1

13

12

1

13

Z

X

Y

# Fig.14

EP 3 282 288 B1

# Fig. 15

13:CONTROL SECTION

50C

12

15 14 14 14 14 14

1(1A)

12:LIGHT
RECEIVING SECTION

1(1B)

13

1(1B)

13

12

1(1B)

Z

Y

X

# Fig. 16

12:LIGHT RECEIVING SECTION

RADIATION SOURCE

50D

13:CONTROL SECTION

Fig. 17

50E:RADIATION SOURCE

12:LIGHT RECEIVING SECTION

13:CONTROL SECTION

13

12

1

14
14
14
14
15

# Fig. 18A

12:LIGHT RECEIVING SECTION                1E

14  
14  
14  
14:SCATTERER DETECTOR

CONTROL SECTION  13

# Fig. 18B

12:LIGHT RECEIVING SECTION                1F

15  
15  
15  
15:ABSORBER DETECTOR

CONTROL SECTION  13

# Fig. 19A

14
14
14
14:SCATTERER DETECTOR

DISTANCE(SMALL)

15
15
15
15:ABSORBER DETECTOR

θ3
θ1 θ2

CONTROL SECTION — 1E
13

CONTROL SECTION — 1F
13

# Fig. 19B

14

14

14

14:SCATTERER
DETECTOR

$\theta 1$ $\theta 2$ $\theta 3$

1E

CONTROL
SECTION

13

DISTANCE (LARGE)

15

15

15

15:ABSORBER
DETECTOR

1F

CONTROL
SECTION

13

# Fig. 20

```
┌─────────────────────┐
│     MEASUREMENT     │
└─────────────────────┘
           │
           │                                        S01
┌──────────────────────────────────────┐
│      SET MODULE ARRANGEMENT DATA       │
│        (SET MEASUREMENT MODE)          │
└──────────────────────────────────────┘
           │
           │                                        S02
┌──────────────────────────────────────┐
│    MEASURE ELECTROMAGNETIC RADIATION   │
│        (READ ANALOG SIGNAL AND         │
│   GENERATE DIGITAL MEASUREMENT DATA)   │
└──────────────────────────────────────┘
           │
           │                                        S03
┌──────────────────────────────────────────────────┐
│   CALCULATE DATA NECESSARY FOR RECONFIGURATION     │
│              OF COMPTON CONE                        │
│   (CALCULATE POSITION X₁ OF COMPTON SCATTERING,    │
│   ENERGY E₁ GIVEN TO RECOIL ELECTRON IN COMPTON    │
│ SCATTERING, POSITION X₂ OF PHOTOELECTRIC ABSORPTION,│
│   ENERGY E₂ ABSORBED BY PHOTOELECTRIC ABSORPTION,  │
│            AND SCATTERING ANGLE θ)                 │
└──────────────────────────────────────────────────┘
           │
           │                                        S04
┌──────────────────────────────────────────────────┐
│   GENERATE RADIATION SOURCE DISTRIBUTION IMAGE     │
└──────────────────────────────────────────────────┘
           │
┌─────────────────────┐
│        END          │
└─────────────────────┘
```

CALCULATE DATA NECESSARY FOR RECONFIGURATION
OF COMPTON CONE
(CALCULATE POSITION $X_1$ OF COMPTON SCATTERING,
ENERGY $E_1$ GIVEN TO RECOIL ELECTRON IN COMPTON
SCATTERING, POSITION $X_2$ OF PHOTOELECTRIC ABSORPTION,
ENERGY $E_2$ ABSORBED BY PHOTOELECTRIC ABSORPTION,
AND SCATTERING ANGLE $\theta$)

# Fig. 21A

12:LIGHT RECEIVING SECTION

1

11

13:CONTROL
SECTION

1

12

11

13

11a

11a

1

12

11

11a

13

11a

1

11a

11a

12

11

11a

13

11a

Z

X

Y

# Fig. 21B

12:LIGHT RECEIVING
      SECTION

13:CONTROL
      SECTION

EP 3 282 288 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2011085418 A
- US 2004251419 A1